(19) **Europäisches Patentamt**
**European Patent Office**
**Office européen des brevets**

(11) **EP 3 809 151 B1**

(12) **EUROPÄISCHE PATENTSCHRIFT**

(45) Veröffentlichungstag und Bekanntmachung des Hinweises auf die Patenterteilung:
**04.09.2024   Patentblatt 2024/36**

(21) Anmeldenummer: **19202976.7**

(22) Anmeldetag: **14.10.2019**

(51) Internationale Patentklassifikation (IPC):
**G01R 33/28** *(2006.01)*   **G01R 33/58** *(2006.01)*
**G01R 33/565** *(2006.01)*   **G01R 33/561** *(2006.01)*

(52) Gemeinsame Patentklassifikation (CPC):
**G01R 33/5659;** G01R 33/288; G01R 33/5612

(54) **COMPUTERIMPLEMENTIERTES VERFAHREN ZUR BEREITSTELLUNG EINER ANSTEUERSEQUENZ UND VERFAHREN ZUR ERFASSUNG VON MESSDATEN DURCH EINE MAGNETRESONANZEINRICHTUNG**

COMPUTER-IMPLEMENTED METHOD FOR PROVIDING A DRIVE SEQUENCE AND METHOD FOR DETECTING MEASUREMENT DATA BY A MAGNETIC RESONANCE DEVICE

PROCÉDÉ MIS EN OEUVRE PAR ORDINATEUR PERMETTANT DE FOURNIR UNE SÉQUENCE DE COMMANDE ET PROCÉDÉ DE DÉTECTION DES DONNÉES DE MESURE À L'AIDE D'UN DISPOSITIF DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.04.2021   Patentblatt 2021/16**

(73) Patentinhaber: **Siemens Healthineers AG**
**91301 Forchheim (DE)**

(72) Erfinder:
• **Gumbrecht, Rene**
**91074 Herzogenaurach (DE)**
• **Herrler, Jürgen**
**91058 Erlangen (DE)**
• **Liebig, Patrick**
**91052 Erlangen (DE)**
• **Nagel, Armin**
**91088 Bubenreuth (DE)**

(74) Vertreter: **Siemens Healthineers**
**Patent Attorneys**
**Postfach 22 16 34**
**80506 München (DE)**

(56) Entgegenhaltungen:
**DE-B4- 102007 013 422      US-A1- 2018 011 155**

• **BOB VAN DEN BERGEN ET AL: "7 T body MRI: B1 shimming with simultaneous SAR reduction; 7 T body MRI: B_{1} shimming with simultaneous SAR reduction", PHYSICS IN MEDICINE AND BIOLOGY, INSTITUTE OF PHYSICS PUBLISHING, BRISTOL GB, vol. 52, no. 17, 7 September 2007 (2007-09-07), pages 5429 - 5441, XP020113056, ISSN: 0031-9155, DOI: 10.1088/0031-9155/52/17/022**

**Beschreibung**

Die Erfindung betrifft ein computerimplementiertes Verfahren zur Bereitstellung einer zu nutzenden Ansteuersequenz, die für eine Erfassung von Messdaten eines Untersuchungsobjekts durch eine Magnetresonanzeinrichtung für mindestens einen Hochfrequenzsendekanal, insbesondere für eine Mehrzahl von Hochfrequenzsendekanälen, einer Antennenanordnung der Magnetresonanzeinrichtung jeweilige abzustrahlende Sendesignale vorgibt. Daneben betrifft die Erfindung ein Verfahren zur Erfassung von Messdaten eines Untersuchungsobjekts durch eine Magnetresonanzeinrichtung, eine Bereitstellungs- und/oder Magnetresonanzeinrichtung, ein Computerprogramm und einen computerlesbaren Datenträger.

Im Bereich der Magnetresonanzbildgebung kann es vorteilhaft sein, hohe Magnetfeldstärken des Hauptmagneten zu nutzen, um eine hohe Bildqualität der Ergebnisdaten zu erreichen. Beispielsweise wird zur Ultrahochfeld-Magnetresonanztomographie eine statische magnetische Flussdichte von ca. 7 Tesla genutzt. Derart hohe Feldstärken des Hauptmagnetfeldes $B_0$ erfordern relativ hochfrequente Anregungspulse mit einer Frequenz von ca. 300 MHz, um Spins im Körper des Untersuchungsobjekts anzuregen. Die Wellenlänge einer solchen elektromagnetischen Welle ist in biologischem Gewebe sehr klein, nämlich im Bereich von ca. 13 cm. Durch die relativ gute Gewebeleitfähigkeit für Hochfrequenzen und Reflektionen an Grenzflächen zwischen verschiedenen biologischen Geweben bzw. biologischem Gewebe und Luft können starke Inhomogenitäten des Anregungsfeldes resultieren. Da zudem hohe statische Feldstärken des $B_0$-Felds genutzt werden, können bereits relativ kleine relative Unterschiede zu großen absoluten Unterschieden in der Feldstärke und somit zu deutlich unterschiedlichen Larmorfrequenzen zwischen verschiedenen Regionen des Untersuchungsobjekts führen.

Die genannten Punkte können bei einer Hochfeldbildgebung dazu führen, dass einige Regionen des Untersuchungsobjekts nur sehr wenig angeregt werden und somit auch kaum messbare Signale generieren. Zudem resultiert typischerweise ein uneinheitlicher Flipwinkel im betrachteten Bereich, was bezüglich der Bildgebung nachteilig ist.

Um eine Magnetresonanztomographie mit entsprechend hohen Feldstärken klinisch nutzbar zu machen, ist es daher erforderlich, eine einfache, vorzugsweise integrierte Lösung zu finden, um die Flipwinkelverteilung zu homogenisieren, wobei vermieden werden sollte, dass eine allzu hohe Mess- und/oder Rechenzeit erforderlich ist bzw. dass eine entsprechende Vorrichtung nur mit hohem technischen Wissen von Anwendern bedient werden kann.

Um eine gleichmäßigere Anregung zu erreichen, kann ein Sendek-Raum abgetastet werden, um eine räumliche Kodierung des $B_1$-Feldes, also des hochfrequenten, zur Spinanregung genutzten Feldes, zu erreichen. Es kann somit eine stärkere bzw. längere Applikation des Hochfrequenzfeldes $B_1$ für Bereiche erfolgen, in denen schwächere Signale erwartet werden. Bei einer Nutzung einzelner Sendeantennen sind bei einem derartigen Vorgehen relativ lange Sendepulse erforderlich, was zu hohen spezifischen Absorptionsraten (SAR) bzw. spezifischen Energiedosen (SED) führen kann, womit eine Anwendung für lebende Untersuchungsobjekte, insbesondere Patienten, problematisch sein kann. Um dies zu vermeiden wird typischerweise das Prinzip der "parallelen Anregung" (pTx) verwendet, bei dem mehrere Sendeantennen als Hochfrequenzspulen genutzt werden, um die Spins im Untersuchungsobjekt anzuregen. Die gleichzeitige Ansteuerung mehrerer solcher Spulen mit gleichzeitiger oder zwischen Ansteuerungen liegender K-Raumabtastung durch Ansteuerung von Gradientenspulen wird auch pTx-Puls genannt.

Bezüglich einer solchen Anregung ist das statische RF-Shimming bzw. $B_1$-Shimming am nächsten an der klinischen Anwendbarkeit. Hierbei werden bei fester und einheitlicher Pulsform jeder Spule individuelle Amplituden und Phasen zugeordnet, um das insgesamt erzeugte $B_1$-Feld während der Anregung zu homogenisieren. Die Amplituden und Phasen können mit Hilfe der vorher akquirierten Sendespulenprofile, also einer $B_1$-Karte, und einer $B_0$-Karte errechnet werden.

Eine potenzielle weitere Verbesserung kann durch dynamisches RF-Shimming bzw. Flipwinkel-Shimming erreicht werden, das jedoch aktuell für die klinische Anwendung noch nicht verwendet wird. Hierbei erfolgt eine Optimierung bezüglich einer zu erreichenden Flipwinkelverteilung am Ende der Anregung, wobei während der Anregung verschiedene und jeweils für sich inhomogene $B_1$-Feldverteilungen zugelassen werden. Für die einzelnen Anregungsspulen wird hierbei jeweils eine eigene Pulsform errechnet und gleichzeitig der k-Raum entlang einer Trajektorie abgetastet. Hierbei wäre es prinzipiell möglich, die genutzte Ansteuersequenz zur Anregung jeweils für das konkrete Untersuchungsobjekt zu optimieren. Dies liefert zwar potenziell die besten Ergebnisse, ist jedoch mit relativ langem Datentransfer- und Rechenzeiten von ca. fünf Minuten verbunden und somit im klinischen Alltag kaum nutzbar.

Eine Alternative, die auf eine klinische Anwendbarkeit abzielt, da sie ohne jedwede Kalibrierung für das einzelne Untersuchungsobjekt und daher ohne zusätzlichen Zeitverlust nutzbar ist, ist die Nutzung von sogenannten "Univeral Pulses". Hierbei erfolgt die Optimierung für eine Kohorte von Referenzuntersuchungsobjekten und die einmal optimierten Pulse werden anschließend ohne weitere Kalibrierung für alle Untersuchungsobjekte genutzt. Details zu diesem Ansatz sind beispielsweise der Druckschrift WO 2017/060142 A1 bzw. dem Artikel Grass, V. (2017), Universal Pulses: A new concept for calibration-free parallel transmission, Magnetic Resonance in Medicine 77:635-643, zu entnehmen. Die zur Abtastung des k-Raums genutzte Trajektorie beruht hierbei auf dem Prinzip der sogenannten $k_T$-Punkte, das beispielsweise im Artikel Cloos, M. A., et al. (2012), kT-Points: Short three-dimensional tailored RF-Pulses for flip-angle homogenization over an extended volume, Magnetic Resonance in Medicine 67:72-80, diskutiert wird. Hierbei wird an verschiedenen errechneten Punkten im k-Raum ein rechteckiger Puls mit spezifischer Amplitude und Phase gesendet. Nachteilig bei der Nutzung von Universalpulsen ist jedoch, dass bei gegebenen Randbedingungen, also beispielsweise bei einer maximal zulässigen spezifischen Absorptionsrate, typischerweise nicht die gleiche Bildqualität erreicht werden kann, wie sie bei einer individuell optimierten Ansteuersequenz möglich wäre.

Im Rahmen der Optimierung von Ansteuersequenzen wird typischerweise als Randbedingung vorgegeben, dass bestimmte spezifische Absorptionsraten nicht überschritten werden dürfen. Ein Ansatz zur Voraussage spezifischer Absorptionsraten für pTx-Pulssequenzen wird in dem Artikel Graesslin, I. et al. (2012), A specific absorption rate prediction concept for parallel transmission MR, Magnetic Resonance in Medicine 68:1664-1674, diskutiert. Hierbei werden SAR-Werte für spezifische Orte im Untersuchungsobjekt, also beispielsweise für einzelne Voxel, ermittelt. Zur Reduktion des erforderlichen Rechenaufwands kann es vorteilhaft sein, sogenannte Virtual Observation Points (VOP) zu nutzen. Bei diesem Ansatz werden, nicht notwendigerweise zusammenhängende, Bereiche für die ein ähnliches Absorptionsverhalten erwartet wird, zusammengefasst und es wird für die jeweiligen Bereiche, also die Virtual Observation Points, ein Maximum für die zu erwartende spezifische Absorptionsrate abgeschätzt. Detaillierte diesbezügliche Informationen sind beispielsweise dem Artikel Eichfelder, G., et al. (2011), Local Specific Absorption Rate Control for Parallel Transmission by Virtual Observation Points, Magnetic Resonance in Medicine 66:1468-1476, zu entnehmen.

Für eine Abschätzung des Energieeintrags werden typischerweise Körpermodelle herangezogen, die die Leitfähigkeit und elektrische Permeabilität verschiedener Körperbereiche beschreiben. Ein Ansatz, entsprechend elektrische Eigenschaften des Gewebes aus Messdaten einer Magnetresonanzeinrichtung zu gewinnen ist aus dem Artikel Zhang, X., et al. (2013), Complex B1 mapping and electrical properties imaging of the human brain using a 16-channel transceiver coil at 7T, Magnetic Resonance in Medicine 69:1285-1296, bekannt.

Die Patentschrift DE 10 2007 013422 B4 beschreibt ein Verfahren zum Steuern einer Magnetresonanzanlage mit einer Hochfrequenzantennenstruktur und mehreren individuell steuerbaren Sendekanälen.

Die Veröffentlichung US 2018/011155 A1 offenbart ein Verfahren zum Einstellen von HF-Shimming-Parametern und insbesondere eine Technik zum Verbessern der Homogenität einer Hochfrequenz-Magnetfeldverteilung, während die Absorptionsmenge elektromagnetischer Wellen im Körpergewebe reduziert wird.

Der Artikel Van den Bergen et al (2007) 7 T body MRI: B1 shimming with simultaneous SAR reduction, Phys Med Biol 52(17):5429-5441 beschreibt eine B1-Shimming-Technik, die gleichzeitig die B+1-Homogenität verbessern und die SAR für die Ganzkörperbildgebung bei 7 T reduzieren kann.

Der Erfindung liegt somit die Aufgabe zugrunde, eine Möglichkeit anzugeben, die erreichbare Bildqualität in Magnetresonanzeinrichtungen gegenüber den obig diskutierten Universalpulsen weiter zu verbessern, wobei vermieden werden soll, allzu lange Mess- bzw. Rechenzeiten für das einzelne Untersuchungsobjekt zu benötigen, sodass insbesondere eine Untersuchungszeit im klinischen Alltag nicht zu stark verlängert wird.

Die Aufgabe wird durch ein computerimplementiertes Verfahren gemäß Anspruch 1 gelöst.

Der Erfindung liegt die Idee zugrunde, einen Großteil der Optimierung in einem vorgelagerten Optimierungsverfahren durchzuführen. Dieses kann unabhängig von den Eigenschaften des Untersuchungsobjekts und insbesondere unabhängig von den am Untersuchungsobjekt erfassten Feldverteilungskarten sein, sodass die Ansteuersequenzen beispielsweise vor Beginn des erfindungsgemäßen Verfahren und insbesondere bevor überhaupt eine Bildgebung am Untersuchungsobjekt erfolgt, also beispielsweise bereits bei der Herstellung oder im Rahmen eines normalen Updates der Magnetresonanzeinrichtung oder einer anderen Bereitstellungseinrichtung, die das computerimplementierte Verfahren durchführt, bereitgestellt werden können.

Um dennoch eine Berücksichtigung der Eigenschaften des konkreten Untersuchungsobjekts zu ermöglichen, werden mehrere verschiedene Ansteuersequenzen bereitgestellt, aus denen in Abhängigkeit von Eigenschaften des Untersuchungsobjekts, nämlich der Feldverteilungskarten, eine zu nutzende Ansteuersequenz ausgewählt wird. Wie später noch genauer erläutert werden wird, gibt der Optimierungsparameter vor, in wie weit der Fokus der Optimierung einerseits auf einer Reduzierung des Energieeintrags in das Untersuchungsobjekt und andererseits auf der möglichst optimalen Erreichung einer Sollanregungsverteilung, also einer vorgegebenen Verteilung von Flipwinkeln, liegt. Anhand der Eigenschaften des Untersuchungsobjekts wird dann ausgewählt, welche dieser Ansteuersequenzen für das konkrete Untersuchungsobjekt besonders gut geeignet ist.

Durch das erfindungsgemäße Vorgehen kann nach Bereitstellung der Ansteuersequenzen und der Feldverteilungskarten mit relativ geringem Rechenaufwand, beispielsweise innerhalb von 5 oder 10 Sekunden bis zwei Minuten, die zu nutzende Ansteuersequenz ausgewählt werden. Die erforderlichen Feldverteilungskarten können in einigen zehn Sekunden, beispielsweise innerhalb von 40 Sekunden, aufnehmbar sein. Die Erfassung der Feldverteilungskarten und die Durchführung des computerimplementierten Verfahrens können somit unmittelbar dem Ausspielen der Ansteuersequenz, also der Messdatenerfassung, vorgelagert sein, wobei dies nur zu einer Verlängerung der Untersuchungszeit von ein bis zwei Minuten führt, womit das beschriebene Vorgehen auch im klinischen Alltag gut einsetzbar ist.

Zugleich wird durch Berücksichtigung der Eigenschaften des Untersuchungsobjekts, nämlich der Feldverteilungskarten, bei der Auswahl der zu nutzenden Ansteuersequenz eine verbesserte Messdatenerfassung gegenüber der Nutzung von Universalpulsen, insbesondere eine höhere Bildqualität bzw. eine bessere Annäherung der erreichten Anregungsverteilung an eine SollAnregungsverteilung, erreicht. Für einige Messprotokolle kann es zudem ohnehin erforderlich sein, dass die erforderlichen Feldverteilungskarten oder zumindest Teile hiervon vor der Durchführung der Messsequenz erfasst werden, sodass der zusätzliche Zeitbedarf zur beschriebenen Wahl der zu nutzenden Ansteuersequenzen noch geringer als die obige Abschätzung sein kann.

Die Ansteuersequenzen können derart ermittelt sein, dass sie abgesehen von der Nutzung eines unterschiedlichen Optimierungsparameters im Rahmen des Optimierungsverfahrens identisch generiert sind. Anders ausgedrückt können sich die Ansteuersequenzen ausschließlich bezüglich des Wertes für genau einen Optimierungsparameter unterscheiden.

Die Durchführung des Optimierungsverfahrens und/oder die Erfassung der Feldverteilungskarten können als vorbereitende Schritte zu dem computerimplementierten Verfahren, also außerhalb des Verfahrens selbst, oder auch als Teil des Verfahrens durchgeführt werden. Es ist beispielsweise auch möglich, dass die verschiedenen Ansteuersequenzen bzw. die Feldverteilungskarten einer Datenbank entnommen werden können, sodass die jeweilige Ermittlung deutlich vor Beginn des computerimplementierten Verfahrens beginnen kann.

Die Ansteuersequenz bzw. die Sendesignale können beispielsweise derart ermittelt werden, dass für den jeweiligen Hochfrequenzsendekanal Parameter bestimmt werden, die eine Pulsform parametrisieren. Insbesondere können diese Parameter eine komplexe Einhüllende für ein Sendesignal mit gegebener Frequenz vorgeben. Die komplexe Einhüllende kann kontinuierlich bzw. quasi kontinuierlich oder diskret für einzelne Punkte im k-Raum jeweils die Amplitude und Phase des Sendesignals für den jeweiligen Hochfrequenzsendekanal vorgeben.

Ein Senden kann nur für spezifische k-Raum Positionen erfolgen, wobei zwischen den einzelnen Sendevorgängen, insbesondere durch die Ansteuersequenz, Gradientenspulen angesteuert werden können, um die k-Raum Position der Anregung zu verändern. Eine solche Anregung an ausgewählten K-Raum Punkten ist beispielsweise aus der eingangs zitierten Veröffentlichung von M. A. Cloos et al. bekannt. Besonders bevorzugt können die Ansteuerungssequenzen durch das Optimierungsverfahren jedoch derart ermittelt sein, dass durchgehend während der Anregung, vorzugsweise durch alle Hochfrequenzsendekanäle gleichzeitig, eine Abstrahlung von Hochfrequenzstrahlung erfolgt. Es ist somit auch möglich, Ansteuersequenzen zu nutzen, die auch während einer Bestromung von Gradientenspulen zur Verschiebung der k-Raum Position eine Ausstrahlung von Hochfrequenzstrahlung über wenigstens einen oder alle der Hochfrequenzsendekanäle vorsehen.

Als Feldverteilungskarten können $B_1$-Karten verwendet werden, die jeweils die räumliche $B_1$-Feldverteilung für eine bestimmte Sendespule, das heißt für einen bestimmten Hochfrequenzsendekanal der Antennenanordnung, angeben. Anders ausgedrückt beschreiben diese $B_1$-Karten die räumliche Sensitivität der entsprechenden Sendespule. Ergänzend oder alternativ kann eine $B_0$-Karte verwendet werden, die räumlich aufgelöst die Abweichungen des Hauptmagnetfeldes von dem eigentlich gewünschten homogenen Feldverlauf repräsentiert. Anders ausgedrückt beschreibt die $B_0$-Karte, wie stark die Larmorfrequenz lokal von der gewünschten Larmorfrequenz abweicht.

Aus den verschiedenen Ansteuersequenzen kann eine vorläufige Ansteuersequenz ausgewählt werden und in Abhängigkeit der Feldverteilungskarten und der vorläufigen Ansteuersequenz kann ein Energieeintrag in einen ausgewählten Bereich des Untersuchungsobjekts bei einer Nutzung der vorläufigen Ansteuersequenz zur Erfassung der Messdaten prognostiziert werden, wobei die zu nutzende Ansteuersequenz oder eine neue vorläufige Ansteuersequenz in Abhängigkeit des prognostizierten Energieeintrags aus den verschiedenen Ansteuersequenzen ausgewählt wird. Eine vorläufige Ansteuersequenz kann insbesondere nur dann als die zu nutzende Ansteuersequenz ausgewählt werden, wenn der prognostizierte Energieeintrag kleiner als ein Grenzwert ist oder in einem Soll- bzw. Toleranzintervall für den Energieeintrag liegt. Ein oberer Grenzwert kann beispielsweise in Abhängigkeit von SAR-Grenzwerten der International Electrotechnical Commission (IEC) und Sequenz- bzw. Protokollparametern der jeweiligen Ansteuersequenz ermittelt werden. Ein Soll- bzw. Toleranzintervall kann so gewählt werden, dass alle Energieeinträge innerhalb dieses Intervalls unterhalb eines so bestimmten Grenzwertes liegen, jedoch nicht um mehr als eine bestimmte Abweichung, beispielsweise eine vorgegebene prozentuale Abweichung.

Die Ansteuersequenz wird iterativ bestimmt. Wird beispielsweise im ersten Durchgang festgestellt, dass die vorläufige Ansteuersequenz zu einem Energieeintrag führt, der größer als ein Grenzwert ist oder außerhalb eines

Soll- bzw. Toleranzintervalls liegt, so wird eine neue Ansteuersequenz aus den vorläufigen Ansteuersequenzen ausgewählt und die Ermittlung des Energieeintrags wiederholt. Dieses Vorgehen wird so lange wiederholt, bis für die aktuelle vorläufige Ansteuersequenz der Energieeintrag kleiner als der Grenzwert ist bzw. in dem Soll- bzw. Toleranzintervall liegt. Die Ansteuersequenz, für die dies der Fall ist, wird als zu nutzende Ansteuersequenz ausgewählt.

Liegt beispielsweise der Energieeintrag für mehrere der vorläufigen Ansteuersequenzen in dem Soll- bzw. Toleranzbereich, so kann diejenige Ansteuersequenz gewählt werden, für die eine optimale Messdatenerfassung erwartet wird, wobei es sich hierbei insbesondere um jene der Messsequenzen mit dem größten noch im Soll- bzw. Toleranzintervall liegenden Energieeintrag handeln kann.

Es kann eine Reihenfolge für die verschiedenen Ansteuersequenzen in Abhängigkeit eines erwarteten Energieeintrags vorgegeben sein. Beispielsweise kann für die verschiedenen Ansteuersequenzen jeweils ein Energieeintrag in wenigstens ein Referenzuntersuchungsobjekt, vorzugsweise in mehrere Referenzuntersuchungsobjekte, prognostiziert werden. Der Energieeintrag bzw. der Durchschnitt dieser Energieeinträge kann dann genutzt werden, um die verschiedenen Ansteuersequenzen gemäß ihres erwarteten Energieeintrags bzw. gemäß eines Parameters, der mit diesem korreliert, zu ordnen. Dies ermöglicht es, wenn der für die vorläufige Ansteuersequenz prognostizierte Energieeintrag außerhalb des Soll- bzw. Toleranzintervalls liegt, in Abhängigkeit davon, ob er oberhalb oder unterhalb dieses Intervalls liegt zu ermitteln, in welche Richtung der Reihenfolge die neue bzw. zu nutzende Ansteuersequenz ausgewählt wird. Wie später noch genauer erläutert werden wird, kann die Auswahl zudem von der Stärke der Abweichung abhängen.

Ein ähnliches Vorgehen ist auch möglich, wenn nur ein oberer Grenzwert für den Energieeintrag vorgegeben wird. Überschreitet der prognostizierte Energieeintrag den Grenzwert, kann anhand der Reihenfolge eine vorläufige Ansteuersequenz mit geringerem Energieeintrag gewählt werden. Liegt der Energieeintrag unterhalb des Grenzwertes kann beispielsweise geprüft werden, ob dies auch für eine neue vorläufige Ansteuersequenz gilt, für die ein etwas höherer Energieeintrag erwartet wird. Somit kann beispielsweise vermieden werden, eine Ansteuersequenz mit unnötig niedrigem Energieeintrag zu nutzen, die typischerweise zu einer suboptimalen Qualität der Messdaten führen würde.

Zunächst kann als vorläufige Ansteuersequenz eine Ansteuersequenz gewählt werden, für die bezüglich des Referenzuntersuchungsobjekts bzw. der Referenzuntersuchungsobjekte ein Energieeintrag prognostiziert wurde, der innerhalb des Soll- bzw. Toleranzintervalls bzw. möglichst nah unterhalb des Grenzwertes liegt. Soweit sich für das Untersuchungsobjekt in Abhängigkeit der Feldverteilungskarten somit ein ähnlicher Energieeintrag ergibt wie für die Referenzuntersuchungsobjekte, kann diese Ansteuersequenz unmittelbar als zu nutzende Ansteuersequenz ausgewählt und bereitgestellt werden. Weicht der in Abhängigkeit der Feldverteilungskarten prognostizierte Energieeintrag hingegen von dem aufgrund der Referenzuntersuchungsobjekte erwarteten Energieeintrag ab, kann, wie obig erläutert, eine andere der verschiedenen Ansteuersequenzen ausgewählt und geprüft werden.

Der relevante Bereich kann insbesondere ein Bereich sein, für den der höchste Energieeintrag prognostiziert wird. Insbesondere kann für mehrere Bereiche des Untersuchungsobjekts ein jeweiliger prognostizierter Energieeintrag ermittelt werden, wobei die zu nutzende Ansteuersequenz oder die neue vorläufige Ansteuersequenz in Abhängigkeit des prognostizierten Energieeintrags in jenem ausgewählten der Bereiche gewählt wird, in dem der prognostizierte Energieeintrag am größten ist. Bei den mehreren Bereichen kann es sich beispielsweise um einzelne Voxel oder um zusammenhängende Gruppen von Voxeln handeln. Besonders bevorzugt handelt es sich bei den einzelnen Bereichen jedoch um die bereits eingangs diskutierten Virtual Observation Points, wie sie im bereits diskutierten Artikel von G. Eichfelder et Al. näher erläutert werden. Wie dort erläutert, kann für einen Virtual Observation Point jeweils eine Obergrenze für in dem zugeordneten Bereich auftretende Energieeinträge ermittelt werden. Diese Obergrenze kann in dem erfindungsgemäßen Verfahren als Energieeintrag für diesen Bereich prognostiziert werden.

Als Energieeintrag kann insbesondere eine lokale spezifische Energiedosis (SED) verwendet werden. Diese beschreibt den Energieeintrag in einen einzelnen Voxel bzw. einen definierten Bereich. Sie kann als Zeitintegral über die lokale spezifische Absorptionsrate verstanden werden. Sind die durch die einzelnen Hochfrequenzsendekanäle an der Position x erzeugten elektrischen Felder $E_c$ bekannt, so kann mit Hilfe der lokalen Leitfähigkeit $\sigma$ und der lokalen Dichte $\rho$ des Gewebes der SED-Wert wie folgt berechnet werden:

$$SED(\vec{x}) = \int dt \; \frac{\sigma(\vec{x})}{2\rho(\vec{x})} \left\| \sum_c \overrightarrow{E_c}(\vec{x}, t) \right\|_2^2$$

Die lokalen Felder können in Abhängigkeit der Steuersignale, die den einzelnen Hochfrequenzsendekanälen zugeführt werden, durch eine elektrodynamische Simulation mit Hilfe eines Körpermodells berechnet werden. Dies ermöglicht zwar eine genaue Bestimmung der elektrischen Felder und somit des SED-Wertes. Da eine entsprechende Berechnung jedoch relativ rechenaufwändig ist und zudem typischerweise kein detailliertes elektrodynamisches Modell für das Untersuchungsobjekt vorliegt, können im erfindungsgemäßen Verfahren vorteilhaft die Feldverteilungskarten verwendet werden, um für eine jeweilige vorläufige Ansteuersequenz den Energieeintrag, also insbesondere den SED-Wert zu berechnen. Hierbei sind die lokalen Magnetfeldstärken B anhand der Feldverteilungskarten bekannt, sodass die lokalen elektrischen Felder E an der Position x aus den Maxwell Gleichungen mit der näherungsweisen Annahme, dass die elektrischen Felder mit der Kreisfrequenz $\omega$, mit der auch die Anregung erfolgt, variieren, wie folgt berechnet werden können:

$$\vec{\nabla} \times \frac{\vec{B}(\vec{x})}{\mu_0} = i\omega\varepsilon(\vec{x})\vec{E}(\vec{x})$$

Hierbei ist $\mu_0$ die magnetische Permeabilität die zumindest näherungsweise mit der Permeabilität des Vakuums gleichgesetzt werden kann. Als einzige Unbekannte zur Berechnung der elektrischen Felder E und somit auch des SED-Wertes verbleibt somit die lokale Permittivität $\varepsilon$. Diese kann jedoch ebenfalls aus den $B_1$-Karten ermittelt werden. Eine Möglichkeit hierfür ist es beispielsweise in der eingangs zitierten Veröffentlichung von X. Zhang erläutert. Demnach kann, wenn die $B_1$-Felder unter Berücksichtigung der Phasenlage erfasst werden, aus den komplexen Werten des $B_1$-Feldes die lokale Permitivität $\varepsilon_c$ ermittelt wie folgt berechnet werden:

$$\frac{\nabla^2 \tilde{B}_1}{\tilde{B}_1} = -\omega^2 \mu_0 \varepsilon_c$$

Wie der gleichen Veröffentlichung zu entnehmen ist, können Phaseninformationen bezüglich der $B_1$-Felder ohne zusätzlichen Messaufwand rekonstruiert werden, indem ein Gleichungssystem gelöst wird, das von den für die einzelnen Hochfrequenzkanäle ermittelten $B_1$-Karten abhängt. Da typischerweise ohnehin für jeden der Hochfrequenzsendekanäle und jede empfangende Antenne $B_1$-Karten ermittelt werden sollen, ist die Ermittlung des Energieeintrags, insbesondere eines SED-Wertes, für das einzelne Untersuchungsobjekt ohne zusätzlichen Messaufwand bzw. allgemein ohne eine Modifikation der genutzten Messeinrichtung möglich.

Die verschiedenen Ansteuersequenzen sind Ergebnisse eines Optimierungsverfahrens, in dessen Rahmen eine Kostenfunktion minimiert wird, die eine gewichtete Summe ist aus

- einem Energieeintragsmaß, das einen erwarteten Energieeintrag in einen Referenzbereich wenigstens eines durch einen jeweiligen Referenzdatensatz beschriebenen Referenzuntersuchungsobjekts bei Nutzung einer zu optimierenden Ansteuersequenz betrifft, und
- einem Abweichungsmaß, das eine Abweichung einer im Rahmen der Ansteuersequenz in dem Referenzuntersuchungsobjekt voraussichtlich erzielten Anregungsverteilung von einer Sollanregungsverteilung betrifft,

wobei die relative Gewichtung des Energieeintragsmaßes und des Abweichungsmaßes durch den Optimierungsparameter vorgegeben wird.

Anders ausgedrückt wird in Abhängigkeit des Optimierungsparameters gewichtet, wie stark der Fokus der Optimierung auf einer Minimierung des Energieeintragsmaßes einerseits oder auf einer Minimierung des Abweichungsmaßes andererseits liegt. Anders ausgedrückt wird für einige der Ansteuersequenzen ein höherer Wert des Energieeintragsmaßes in Kauf genommen, um eine stärkere Optimierung bezüglich des Abweichungsmaßes zu erreichen. Somit resultieren für gleiche Referenzdatensätze in Abhängigkeit des vorgegebenen Optimierungsparameters unterschiedliche Ansteuersequenzen. Insbesondere werden die verschiedenen Ansteuersequenzen abgesehen von der Nutzung von verschiedenen Werten für den Optimierungsparameter alle auf gleiche Weise ermittelt.

Aufgrund der erläuterten Optimierung für verschiedene Werte des Optimierungsparameters stehen verschiedene Ansteuersequenzen zur Verfügung, aus denen bedarfsgerecht ausgewählt werden kann. Somit kann, wenn für die vorläufige Ansteuersequenz ein Energieeintrag bei der Untersuchung des Untersuchungsobjekts prognostiziert wird, der einen Grenzwert überschreitet, eine andere der verschiedenen Ansteuerungssequenzen ausgewählt werden, bei der im Rahmen der Optimierung das Energieeintragsmaß stärker gewichtet wurde, womit voraussichtlich ein geringerer Energieeintrag erreicht werden kann. Andererseits kann für den Fall, dass ein niedriger prognostizierter Energieeintrag ermittelt wird, eine andere der verschiedenen Ansteuersequenzen gewählt werden, bei der der Fokus der Optimierung stärker auf einer Minimierung des Abweichungsmaßes lag, da hierdurch im Rahmen des zulässigen Energieeintrags voraussichtlich eine Anregungsverteilung erreicht werden kann, die näher an einer Sollanregungsverteilung liegt.

Das Abweichungsmaß kann beispielsweise als Standardabweichung zwischen der voraussichtlich erzielten Anregungsverteilung und einer Sollanregungsverteilung ermittelt werden. Hierbei kann die Standardabweichung gemeinsam für alle Referenzuntersuchungsobjekte oder separat für die einzelnen Untersuchungsobjekte berechnet werden. Bei einer separaten Berechnung kann anschließend beispielsweise die Summe oder der Durchschnitt dieser Standardabweichungen als Abweichungsmaß verwendet werden.

Als Energieeintragsmaß kann insbesondere der obig erläuterte SED-Wert bzw. ein anderes Maß für die spezifische Energiedosis, die in ein Referenzuntersuchungsobjekt bzw. einen Bereich des Referenzuntersuchungsobjekts eingebracht wird, verwendet werden. Hierbei kann zunächst ein separater Wert für jedes der Untersuchungsobjekte berechnet werden und diese Werte können addiert werden bzw. es kann ein Durchschnitt gebildet werden.

Verschiedene Ansätze zur Ermittlung von Anregungsverteilungen bzw. erwarteten Energieeinträgen im Rahmen einer Messsequenz sind aus dem Stand der Technik wohl bekannt und sollen nicht detailliert erläutert werden. Die Referenzdatensätze können jeweils ein numerisches Körpermodell für eine elektrodynamische Simulation vorgeben, es ist jedoch auch ausreichend, Feldverteilungskarten für das jeweilige Referenzuntersuchungsobjekt vorzugeben. Bei der Ermittlung einer Ansteuersequenz, die die Kostenfunktion minimiert, handelt es sich typischerweise um ein nicht-konvexes Optimierungsproblem, sodass es im Rahmen des Optimierungsverfahrens vorteilhaft sein kann, das Optimierungsverfahren mit mehreren Startpunkten durchzuführen, um ein robustes Auffinden eines globalen Minimums zu ermöglichen.

In dem Optimierungsverfahren können mehrere der Referenzuntersuchungsobjekte berücksichtigt werden, wobei für jedes der Referenzuntersuchungsobjekte und jede der verschiedenen Ansteuersequenzen ein Einzelenergieeintrag ermittelt wird, der einen erwarteten Energieeintrag in den Referenzbereich dieses Referenzuntersuchungsobjekts bei Nutzung dieser Ansteuersequenz betrifft, wobei für jede der verschiedenen Ansteuersequenzen ein Mittelwert der Einzelenergieeinträge bestimmt und dem zur Ermittlung der jeweiligen Ansteuersequenz genutzten Optimierungsparameter oder der Ansteuersequenz selbst zugeordnet wird. Beispielsweise können 10-20 Referenzuntersuchungsobjekte berücksichtigt werden. Es ist jedoch möglich, eine größere oder kleinere Zahl von Referenzuntersuchungsobjekten zu berücksichtigen.

Es wurde erkannt, dass Energieeinträge zwar bei Nutzung der gleichen Ansteuersequenz zwischen verschiedenen Untersuchungsobjekten bzw. Referenzuntersuchungsobjekten unterschiedlich sein können, hierbei jedoch klare Tendenzen auftreten. Resultiert beispielsweise für eine erste Ansteuersequenz ein Mittelwert der Einzelenergieeinträge, der deutlich größer ist als der Mittelwert der Einzelenergieeinträge für eine zweite Ansteuersequenz, so ist bei Berücksichtigung einer ausreichend repräsentativen Gruppe von Referenzuntersuchungsobjekten typischerweise davon auszugehen, dass auch für das Untersuchungsobjekt aus der ersten Ansteuersequenz ein höherer Energieeintrag resultieren wird als aus der zweiten Ansteuersequenz. Es kann somit, wie bereits obig angesprochen, eine Reihenfolge der verschiedenen Ansteuersequenzen bezüglich des durch sie zu erwartenden Energieeintrags festgelegt werden. Dies ermöglicht es, bedarfsgerecht Ansteuersequenzen mit geringerem Energieeintrag oder Ansteuersequenzen mit höherem Energieeintrag, die typischerweise eine gleichmäßigere Anregung ermöglichen, auszuwählen.

Für die jeweilige Ansteuersequenz kann für mehrere Bereiche des jeweiligen Referenzuntersuchungsobjekts ein jeweiliger erwarteter Energieeintrag ermittelt werden, wobei als Einzelenergieeintrag für diese Ansteuersequenz und dieses Referenzuntersuchungsobjekt der größte dieser erwarteten Energieeinträge gewählt wird. Anders ausgedrückt wird für jedes der Referenzuntersuchungsobjekte jeweils jener Bereich als Referenzbereich gewählt, für den der größte Energieeintrag ermittelt wird. Es werden somit potenzielle Hotspots, in denen ein besonders hoher Energieeintrag erfolgt, erkannt und berücksichtigt. Hierdurch kann insbesondere erkannt werden, wenn eine bestimmte Ansteuersequenz lokal in einem oder mehreren Bereichen zu einem besonders hohen Energieeintrag und somit potenziell zu einer starken Erhitzung führt.

Dies wird einerseits im Rahmen der Optimierung berücksichtigt, da das Energieeintragsmaß einen erwarteten Energieeintrag in den Referenzbereich und somit den maximal für irgendeinen Bereich auftretenden Energieeintrag betrifft. Zugleich führen Ansteuersequenzen, die zu entsprechenden Hotspots in zumindest einem der Referenzuntersuchungsobjekte führen, dazu, dass der Mittelwert der Einzelenergieeinträge merklich erhöht wird, womit diese Eigenschaft auch bei der Auswahl der vorläufigen Ansteuersequenz bzw. der neuen vorläufigen Ansteuersequenz bzw. der zu nutzenden Ansteuersequenz berücksichtigt werden kann. Da wie obig erläutert im Rahmen der Ermittlung der zu nutzenden Ansteuersequenz insbesondere ein konkreter prognostizierter Energieeintrag für das Untersuchungsobjekt selbst anhand der bereitgestellten Feldverteilungskarten ermittelt wird, können bei der Auswahl Ansteuersequenzen verworfen werden, die für das konkrete Untersuchungsobjekt zur Ausbildung von nicht tolerierbaren Hotspots führen würden.

In Abhängigkeit der den jeweiligen Optimierungsparametern zugeordneten Mittelwerte der Einzelenergieeinträge kann ein funktionaler Zusammenhang zwischen den Optimierungsparametern und den zugeordneten Mittelwerten ermittelt werden, wobei die zu nutzende Ansteuersequenz und/oder die vorläufige und/oder die neue vorläufige Ansteuersequenz in Abhängigkeit dieses funktionalen Zusammenhangs gewählt werden. Insbesondere kann als funktionaler Zusammenhang ein polynominaler Zusammenhang ermittelt werden. Der funktionale Zusammenhang kann beispielsweise durch einen Fit bzw. eine Regressionsanalyse ermittelt werden. Der funktionale Zusammenhang kann insbesondere bei Nutzung einer relativ großen Zahl von verschiedenen Ansteuersequenzen bzw. von Werten des Optimierungsparameters das Auffinden eines geeigneten Optimierungsparameters bzw. einer geeigneten Ansteuersequenz deutlich beschleunigen.

Wird beispielsweise für eine vorläufige Ansteuersequenz ein Energieeintrag prognostiziert, der einen Sollwert um einen bestimmten Offset oder Skalierungsfaktor überschreitet, kann ein Zwischenwert berechnet werden, der um diesen Offset bzw. Skalierungsfaktor kleiner als der bisherige Sollwert ist und anhand des funktionalen Zusammenhangs kann ein zugeordneter Wert für den Optimierungsparameter bestimmt werden. Die neue vorläufige Ansteuersequenz kann dann so gewählt werden, dass ihr Optimierungsparameter möglichst nah an dem so ermittelten Optimierungsparameter liegt. Durch ein solches Vorgehen kann eine geeignete Ansteuersequenz typischerweise innerhalb von wenigen Iterationsschritten ermittelt werden.

Vorzugsweise umfassen die verschiedenen Ansteuersequenzen zusätzlich jeweils Ansteuerinformationen zur Ansteuerung wenigstens einer Gradientenspule zur Bereitstellung eines Gradientenfeldes. Die Ansteuersequenzen können beispielsweise jeweils einen zeitlichen Verlauf der Gradientenfelder beschreiben, der im Rahmen der Nutzung der Ansteuersequenz synchron mit den Hochfrequenzpulsen also den Sendesignalen für die Hochfrequenzsendekanäle, ausgespielt wird. Der zeitliche Verlauf der Gradientenfelder beschreibt eine k-Raum Trajektorie für die Anregung. Die Kombination von Gradientenfeldern und Hochfrequenzpulsen zum Erreichen einer gleichmäßigeren Anregung ist aus dem Stand der Technik wohlbekannt und soll nicht detailliert erläutert werden. Im einfachsten Fall wäre es möglich, die gleiche k-Raum Trajektorie allen Ansteuersequenzen zu nutzen. Da die genutzte k-Raum Trajektorie bzw. die Ansteuerinformationen zur Ansteuerung der wenigstens einen Gradientenspule die resultierende Anregungsverteilung beeinflussen, werden entsprechende Informationen auch in der obig erläuterten Optimierung berücksichtigt. Die Nutzung einer festen k-Raum Trajektorie kann den Rechenaufwand für eine Optimierung reduzieren.

Es kann jedoch vorteilhaft sein, verschiedene Ansteuersequenzen mit verschiedenen Ansteuerinformationen zur Ansteuerung der wenigstens einen Gradientenspule, in anderen Worten Ansteuersequenzen, die verschiedene k-Raum Trajektorien nutzen, zu verwenden. Dies führt zwar dazu, dass im Rahmen der Optimierung mehr freie Parameter vorliegen, womit der Rechenaufwand zur Optimierung erhöht sein kann.

Da die Ermittlung der verschiedenen Ansteuertrajektorien durch das Optimierungsverfahren in dem erfindungsgemäßen Verfahren jedoch von Daten des konkreten Untersuchungsobjekts unabhängig ist und daher vorgelagert durchgeführt werden kann, ist es problemlos möglich, ein Optimierungsverfahren durchzuführen, das sehr viel Rechenleistung in Anspruch nimmt. Beispielsweise kann das optimierungsverfahren auf einem Rechnercluster oder Großrechner durchgeführt werden und mehrere Stunden oder Tage benötigen. Dies wird dadurch ermöglicht, dass eine entsprechende Optimierung nur einmalig erforderlich ist, wonach die verschiedenen Ansteuersequenzen für eine Vielzahl von Untersuchungsobjekten verwendet werden können.

Die verschiedenen Ansteuersequenzen können beispielsweise durch den Hersteller einer Magnetresonanzeinrichtung oder einen anderen Dienstleister bereitgestellt werden. Sie können beispielsweise auf einer Magnetresonanzeinrichtung, einem externen Server, in einer Cloud oder Ähnlichem gespeichert sein und bedarfsgerecht bereitgestellt werden.

Neben dem obig erläuterten Verfahren zur Bereitstellung einer zu nutzenden Ansteuersequenz betrifft die Erfindung auch ein Verfahren zur Erfassung von Messdaten eines Untersuchungsobjekts, insbesondere zur medizinischen Bildgebung, durch eine Magnetresonanzeinrichtung, wobei durch eine Antennenanordnung der Magnetresonanzeinrichtung im Rahmen der Messdatenerfassung über mindestens einen Hochfrequenzsendekanal, insbesondere über ein Mehrzahl von Hochfrequenzsendekanälen, Sendesignale abgestrahlt werden, die durch eine Ansteuersequenz vorgegeben werden, die durch das erfindungsgemäße computerimplementierte Verfahren zur Bereitstellung einer zu nutzenden Ansteuersequenz ausgewählt ist.

Wie obig erläutert können die Ansteuersequenzen zusätzlich Ansteuersignale zur Ansteuerung wenigstens einer Gradientenspule zur Bereitstellung eines Gradientenfeldes umfassen. In diesem Fall kann durch eine Steuereinrichtung der Magnetresonanzeinrichtung auch wenigstens eine Gradientenspule zur Bereitstellung eines Gradientenfeldes durch die entsprechenden Ansteuerinformationen angesteuert werden.

Durch die Magnetresonanzeinrichtung kann die Feldverteilungskarte erfasst werden, in Abhängigkeit der die zu nutzende Ansteuersequenz bereitgestellt wird. Insbesondere kann die Erfassung der Feldverteilungskarten unmittelbar vor der Messdatenerfassung bzw. ohne eine Umlagerung des Untersuchungsobjekts erfolgen. Beispielsweise kann vor einer Messdatenerfassung zunächst eine Erfassung der Feldkarten, beispielsweise für ca. vierzig Sekunden, erfolgen. Wie bereits obig erläutert ist die Rechenzeit in dem erfindungsgemäßen Verfahren zur Bereitstellung der Ansteuersequenz relativ gering, sodass der Gesamtzeitaufwand für das Erfassen der Feldkarten und die Berechnung beispielsweise nur ein bis zwei Minuten sein kann.

Zugleich wird durch die Bereitstellung von mehreren verschiedenen Ansteuersequenzen und die Auswahl der zu nutzenden Ansteuersequenz in Abhängigkeit der Feldverteilungskarten jedoch erreicht, dass ein zu hoher Energieeintrag in das Untersuchungsobjekt robust vermieden werden kann und zudem bei gleichem zulässigen Energieeintrag typischerweise eine Abweichung der erreichten Anregungsverteilung von einer Sollanregungsverteilung deutlich reduziert werden kann. Somit wird die Qualität der Messdatenerfassung, insbesondere die Bildqualität, erheblich verbessert.

Neben dem erfindungsgemäßen Verfahren betrifft die Erfindung eine Bereitstellungs- und/oder Magnetresonanzeinrichtung, die zur Durchführung des erfindungsgemäßen computerimplementierten Verfahrens zur Bereitstellung einer zu nutzenden Ansteuersequenz und/oder zur Durchführung des Verfahrens zur Erfassung von Messdaten eines Untersuchungsobjekts ausgebildet ist.

Soll eine Bereitstellungsvorrichtung ausschließlich das computerimplementierte Verfahren zur Bereitstellung einer zu nutzenden Ansteuersequenz implementieren, kann es sich bei der Bereitstellungsvorrichtung um eine reine Datenverarbeitungseinrichtung handeln. Hierbei können allgemeine Datenverarbeitungseinrichtungen beispielsweise entsprechend programmiert werden, um eine erfindungsgemäße Bereitstellungsvorrichtung bereitzustellen. Die Datenverarbeitung kann beispielsweise durch einen Mikroprozessor, Mikrocontroller, FPGA oder ähnliches erfolgen.

Eine entsprechende Datenverarbeitungseinrichtung kann in eine Vorrichtung zur Messdatenerfassung, beispielsweise eine Magnetresonanzeinrichtung, integriert sein, oder separat hiervon ausgebildet sein. Die Datenverarbeitung kann lokal oder auch auf einem Server oder in einer Cloud erfolgen. Eine entsprechende Bereitstellungsvorrichtung kann auch dazu eingerichtet sein, das Optimierungsverfahren zur Ermittlung der verschiedenen Ansteuersequenzen durchzuführen. Vorzugsweise wird dieses Optimierungsverfahren jedoch auf einer separaten Einrichtung durchgeführt und die verschiedenen Ansteuersequenzen werden beispielsweise im Rahmen der Installation oder Konfiguration der Bereitstellungsvorrichtung bereitgestellt, bedarfsgerecht über eine Netzwerkverbindung abgerufen oder Ähnliches.

Die erfindungsgemäße Magnetresonanzeinrichtung umfasst insbesondere eine Steuereinrichtung, durch die die Antennenanordnung der Magnetresonanzeinrichtung und optional wenigstens eine Gradientenspule zur Bereitstellung eines Gradientenfeldes gesteuert werden. Die Steuereinrichtung ist dazu eingerichtet, die zu nutzende Ansteuersequenz auszuspielen, um die Hochfrequenzsendekanäle und optional die wenigstens eine Gradientenspule entsprechend anzusteuern.

Neben den genannten Komponenten kann die erfindungsgemäße Magnetresonanzeinrichtung auch weitere übliche Komponenten von Magnetresonanzeinrichtungen umfassen, insbesondere einen Hauptmagneten zur Bereitstellung eines $B_0$-Feldes, eine Vorrichtung zur Lagerung des Untersuchungsobjekts, etc.

Der prinzipielle Aufbau von Magnetresonanzeinrichtungen ist im Stand der Technik wohlbekannt und soll daher nicht detailliert erläutert werden.

Die Erfindung betrifft zudem ein Computerprogramm für eine Datenverarbeitungseinrichtung, mit Programmanweisungen, die bei einer Durchführung auf einer Datenverarbeitungseinrichtung das computerimplementierte Verfahren zur Bereitstellung einer zu nutzenden Ansteuersequenz und/oder das erfindungsgemäße Verfahren zur Erfassung von Messdaten eines Untersuchungsobjekts durchführen. Die Datenverarbeitungseinrichtung kann eine programmierbare Einrichtung sein, wie bereits obig erläutert wurde.

Zudem betrifft die Erfindung einen computerlesbaren Datenträger, der ein erfindungsgemäßes Computerprogramm umfasst.

Weitere Vorteile und Einzelheiten der vorliegenden Erfindung ergeben sich aus den im Folgenden beschriebenen Ausführungsbeispielen sowie anhand der Zeichnungen. Dabei zeigen schematisch:

Fig. 1 Ein Ausführungsbeispiel einer erfindungsgemäßen Magnetresonanzeinrichtung, die dazu eingerichtet ist, ein Ausführungsbeispiel eines erfindungsgemäßen Verfahrens zur Erfassung von Messdaten eines Untersuchungsobjekts durchzuführen, sowie ein Ausführungsbeispiel einer erfindungsgemäßen Bereitstellungseinrichtung, die dazu eingerichtet ist, ein Ausführungsbeispiel des erfindungsgemäßen computerimplementierten Verfahrens zur Bereitstellung einer zu nutzenden Ansteuersequenz auszuführen,

Fig. 2 ein Ablaufdiagram eines Ausführungsbeispiels eines erfindungsgemäßen Verfahrens zur Erfassung von Messdaten eines Untersuchungsobjekts, im Rahmen dessen ein Ausführungsbeispiel des erfindungsgemäßen computerimplementierten Verfahrens zur Bereitstellung einer zu nutzenden Ansteuersequenz durchgeführt wird,

Fig. 3 die im Rahmen des Verfahrens gemäß Fig. 2 genutzten Datenstrukturen und Algorithmen,

Fig. 4 eine detaillierte Darstellung des in Fig. 3 genutzten Optimierungsalgorithmus, und

Fig. 5 ein Ablaufdiagramm eines Ausführungsbeispiels eines computerimplementierten Verfahrens zur Bereitstellung einer zu nutzenden Ansteuersequenz.

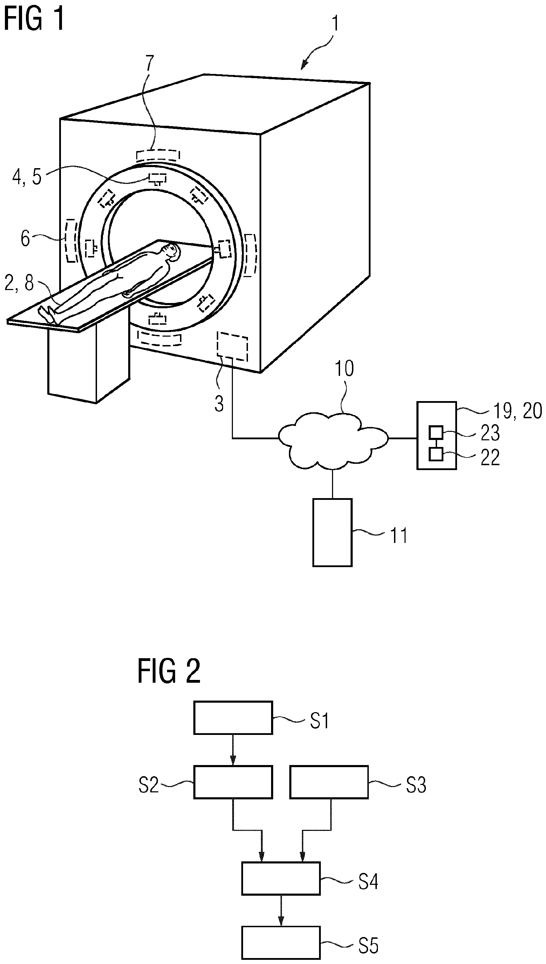

Fig. 1 zeigt eine Magnetresonanzeinrichtung 1, die zur Erfassung von Messdaten eines Untersuchungsobjekts 2, insbesondere zur Bildgebung, dient. Die Magnetresonanzeinrichtung 1 umfasst eine Steuereinrichtung 3, die gemäß einer bestimmten Ansteuersequenz mehrere Komponenten der Magnetresonanzeinrichtung ansteuert, um Bereiche des Untersuchungsobjekts 2 selektiv anzuregen und entsprechende Messdaten zu erfassen. Von diesen Komponenten sind in Fig. 1 beispielhaft eine Antennenanordnung 4 gezeigt, die im Beispiel acht Hochfrequenzsendekanäle 5 umfasst, um Hochfrequenzsignale abzustrahlen und hierdurch Spins im Untersuchungsobjekt 2 anzuregen. Ergänzend sind mehrere Gradientenspulen 6, 7 dargestellt, die zur Bereitstellung von Gradientenfeldern dienen, die sich mit einem durch einen Hauptmagneten (hier nicht dargestellt) erzeugten Hauptmagnetfeld $B_0$ überlagern. Die Ansteuerung der Gradientenspulen 6, 7 kann durch die Steuereinrichtung 3 anhand von Ansteuerinformationen folgen, die Teil der Ansteuersequenz sind.

Die Steuereinrichtung 3 kann die einzelnen Hochfrequenzsendekanäle 5 und insbesondere auch die Gradientenspulen 6, 7 insbesondere durch eine Ansteuersequenz ansteuern, die das Prinzip der parallelen Anregung (pTx) umsetzt. Hierbei werden die Hochfrequenzsendekanäle 5 und somit auch die entsprechenden Antennen bzw. Sendespulen gleichzeitig mit einem gewissen zeitlichen Muster angesteuert, wobei gleichzeitig oder abwechselnd durch die Gradientenspulen 6, 7 eine k-Raum Abtastung erfolgt. Eine Möglichkeit, eine solche Sequenz für eine vorgegebene k-Raum Trajektorie, das heißt für eine vorgegebene Abfolge von Steuersignalen für die Gradientenspulen 6, 7, vorzugeben, ist, eine komplexe einhüllende für jeden der Hochfrequenzsendekanäle 5 vorzugeben, die zu jedem Zeitpunkt eine Amplitude und Phase des Sendesignals vorgibt. Die Einhüllende kann mit sehr hoher zeitlicher Auflösung, also quasi-kontinuierlich, vorgegeben sein, oder es kann eine Vorgabe für zeitlich beabstandete Punkte erfolgen.

Prinzipiell wäre es möglich, eine Ansteuersequenz der Magnetresonanzeinrichtung individuell auf das einzelne Untersuchungsobjekt 2 und seine konkrete Lage in der Magnetresonanzeinrichtung 1 zu optimieren. Aufgrund der großen möglichen Parameterzahl würde dies jedoch eine Untersuchungsdauer erheblich verlängern, womit eine entsprechende individuelle Optimierung im klinischen Alltag voraussichtlich nicht umsetzbar sein wird.

Es wurde jedoch erkannt, dass bereits durch individuelle Auswahl der zu nutzenden Ansteuersequenz aus mehreren verschiedenen vorgegebenen Ansteuersequenzen gegenüber einer Nutzung der gleichen Ansteuersequenz für alle Untersuchungsobjekte eine erhebliche Verbesserung der Messdatenerfassung bzw. der Bildgebung erreicht werden kann.

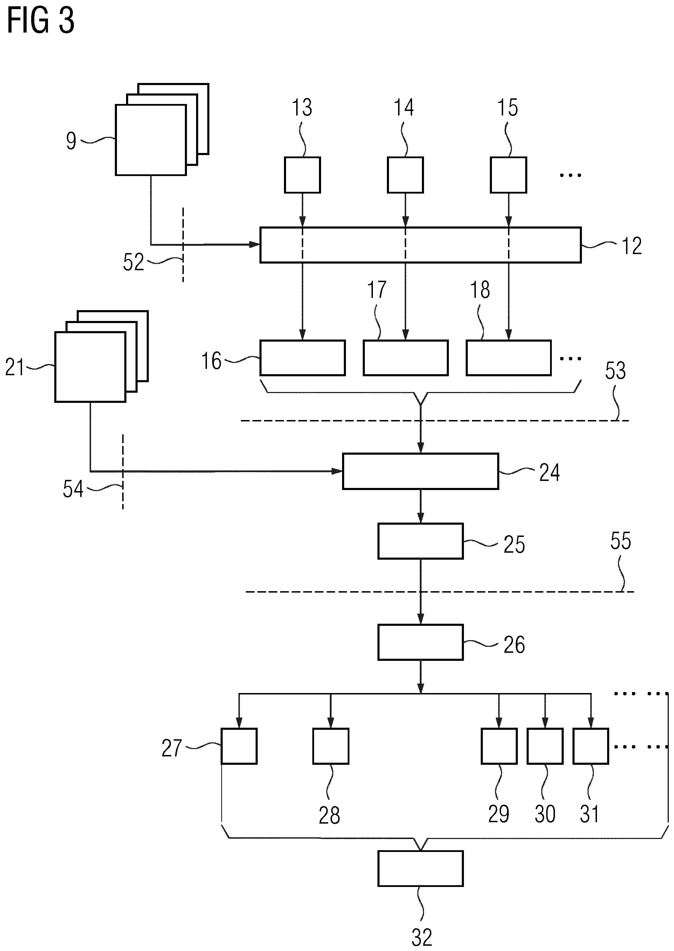

Ein entsprechendes Vorgehen wird im Folgenden zusätzlich mit zusätzlichem Bezug auf Fig. 2 und 3 erläutert. Hierbei werden zum besseren Verständnis des erläuterten Vorgehens verschiedene Verfahren, die auch separat verwendet werden können, sowie vorbereitende Schritte für diese Verfahren gemeinsam erläutert. Da jedoch die verschiedenen Verfahren durch verschiedene Nutzer auf verschiedenen Einrichtungen durchgeführt werden können, ist es auch möglich, die einzelnen Verfahren separat zu nutzen.

Fig. 2 zeigt ein Ablaufdiagram des gesamten Ablaufs zur Erfassung von Messdaten eines Untersuchungsobjekts 2 und Fig. 3 zeigt die hierbei genutzten Datenstrukturen und Algorithmen. Die Vorrichtungen, durch die die entsprechenden Schritte implementiert werden, sind in Fig. 1 dargestellt.

In Schritt S1 werden zunächst Referenzdatensätze 9 bereitgestellt, die jeweils ein Referenzuntersuchungsobjekt 8 betreffen. Die Referenzdatensätze sollen es im späteren Verfahrensverlauf ermöglichen, für eine gegebene Ansteuersequenz eine Anregungsverteilung im Referenzuntersuchungsobjekt sowie einen Energieeintrag in wenigstens einem Referenzbereich des Untersuchungsobjekts zu bestimmen. Die Referenzdatensätze können ein detailliertes elektrodynamisches Modell des jeweiligen Referenzuntersuchungsobjekts beschreiben. Es kann jedoch auch ausreichen, Feldverteilungskarten, insbesondere $B_0$- und $B_1$-Karten des jeweiligen Referenzuntersuchungsobjekts als Referenzdatensatz bereitzustellen und anhand dieser Daten beispielsweise ein vorgegebenes elektrodynamisches Modell zu modifizieren. Die Referenzdatensätze können beispielsweise durch die gleiche Magnetresonanzeinrichtung 1 aufgenommen werden, indem statt dem Untersuchungsobjekt 2 das jeweilige Referenzuntersuchungsobjekt 8 untersucht wird. Da die folgende Optimierung jedoch typischerweise herstellerseitig oder durch einen anderen Dienstleister erfolgen soll, kann es vorteilhaft sein, entsprechende Referenzdatensätze außerhalb des klinischen Alltags aufzunehmen, beispielsweise indem eine oder mehrere, insbesondere baugleiche, Magnetresonanzeinrichtungen genutzt werden, um die Referenzdatensätze zu erfassen bzw. Messdaten zu erfassen, anhand derer die Referenzdatensätze ermittelt werden.

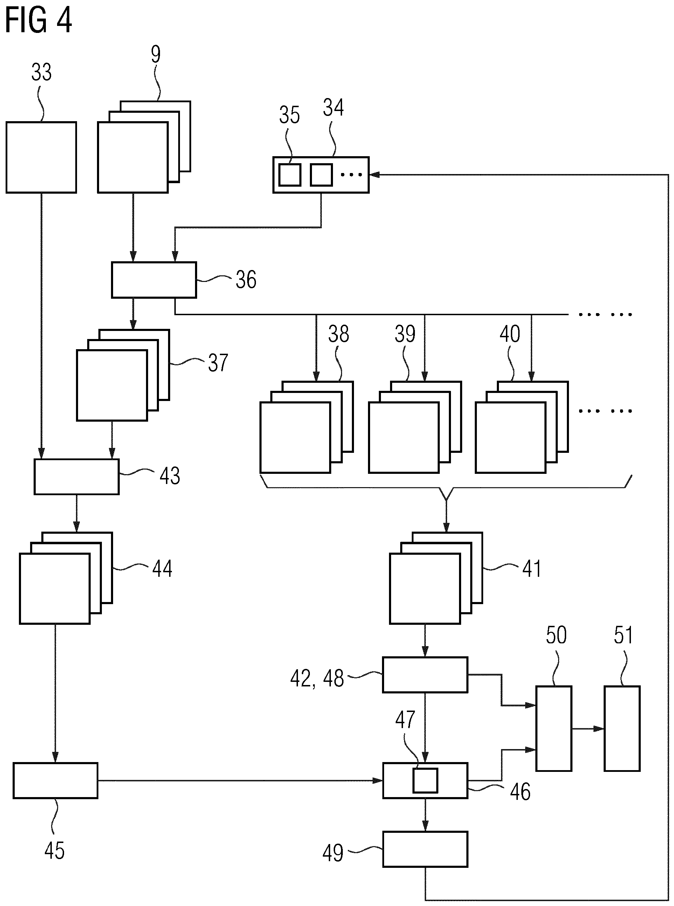

Wie in Fig. 3 dargestellt ist, werden die Referenzdatensätze 9 durch ein Optimierungsverfahren 12 verarbeitet, das später noch im Detail mit Bezug auf Fig. 4 erläutert werden wird. Wesentlich ist hierbei zunächst, dass sich die durch das Optimierungsverfahren 12 ermittelten Ansteuersequenzen 16, 17, 18 bezüglich eines bei der Ermittlung der jeweiligen Ansteuersequenz 16, 17, 18 genutzten Optimierungsparameters 13, 14, 15 unterscheiden. Die Optimierung erfolgt hierbei insbesondere bezüglich eines Abweichungsmaßes, das eine Abweichung einer im Rahmen der jeweiligen Ansteuersequenz 16, 17, 18 in dem Referenzuntersuchungsobjekt 8 voraussichtlich erzielten Anregungsverteilung von einer Sollanregungsverteilung betrifft, und bezüglich eines Energieeintrags in einen Referenzbereich der Referenzuntersuchungsobjekte 8. Der Optimierungsparameter kann vorgeben, auf welche dieser Größen im Rahmen der Optimierung der Schwerpunkt gelegt wird.

Schritt S2 bzw. die in Fig. 3 zwischen den gestrichelten Linien 52 und 53 dargestellte Datenverarbeitung kann auf einer Optimierungseinrichtung 11 als vorbereitende Berechnung erfolgen, die beispielsweise herstellerseitig einmalig durchgeführt wird.

In Schritt S3 werden Feldverteilungskarten 21 bezüglich des Untersuchungsobjekts 2 erfasst. Hierbei werden insbesondere $B_0$- und $B_1$-Karten erfasst. Bezüglich der $B_1$-Karten kann insbesondere anhand bekannter Sendesignale der einzelnen Hochfrequenzsendekanäle 5 und der über die verschiedenen Antennen empfangenen Empfangssignale eine Phaseninformationen umfassende $B_1$-Karte ermittelt werden.

Die in Schritt S2 durch die Optimierungseinrichtung 11 ermittelten verschiedenen Ansteuersequenzen 16, 17, 18 sowie die durch die Magnetresonanzeinrichtung 1 in Schritt S3 ermittelten Feldverteilungskarten 21 werden, im Beispiel gemäß Fig. 1 über das Netzwerk 10, an eine Bereitstellungseinrichtung 19 übermittelt. Die Bereitstellungseinrichtung 19 ist im Beispiel eine separate Einrichtung. Sie könnte jedoch auch in die Magnetresonanzeinrichtung 1 oder in die Optimierungseinrichtung 11 integriert sein. Die Bereitstellungseinrichtung 19 ist eine Datenverarbeitungseinrichtung 20 mit einem Prozessor 23 und einem Speicher 22. In den Speicher 22 kann beispielsweise ein Computerprogramm geladen werden, das das im Folgenden erläuterte computerimplementierte Verfahren zur Bereitstellung einer zu nutzenden Ansteuersequenz implementiert.

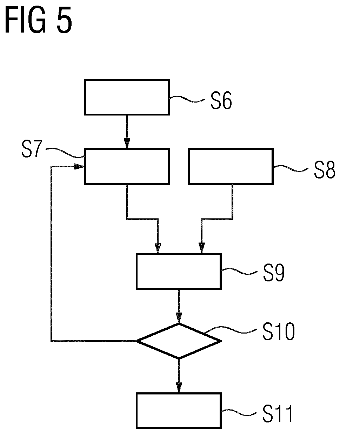

Das computerimplementierte Verfahren 24 wählt in Schritt S4 in Abhängigkeit der Feldverteilungskarten 21 eine der verschiedenen Ansteuersequenzen 16, 17, 18 als zu nutzende Ansteuersequenz 25 aus und stellt diese, im Beispiel über das Netzwerk 10, an die Steuereinrichtung 3 der Magnetresonanzeinrichtung 1 bereit. Wie später noch genauer mit Bezug auf Fig. 5 erläutert werden wird, ist hierbei ein iteratives Vorgehen vorgesehen , bei dem zunächst eine vorläufige Ansteuersequenz ausgewählt wird, für die ein Energieeintrag in das Untersuchungsobjekt 2 bzw. in wenigstens einen Bereich des Untersuchungsobjekts 2 prognostiziert wird. Wird ermittelt, dass dieser voraussichtliche Energieeintrag zu groß ist, beispielsweise oberhalb eines Grenzwertes oder eines Toleranzintervalls liegt, so wird eine andere der verschiedenen Ansteuersequenzen gewählt und diese Überprüfung wiederholt. Auch bei einem zu kleinen Energieeintrag kann eine andere der vorläufigen Ansteuersequenzen gewählt werden, da versucht werden kann, durch einen höheren aber noch zulässigen Energieeintrag die Qualität der Messdatenerfassung zu verbessern.

Die gesamte Datenverarbeitung in Schritt S4, also der Bereich in Fig. 3 zwischen den Linien 53, 54 und 55, kann als separates Verfahren unabhängig von den weiteren Schritten auf einer separaten Einrichtung, im Beispiel auf der Bereitstellungseinrichtung 19, beispielsweise durch einen Dienstleister oder den Hersteller des Magnetresonanztomographen 1, durchgeführt werden.

In Schritt S5 wird das Verfahren 26 zur Erfassung von Messdaten eines Untersuchungsobjekts 2 verwendet, um die Gradientenspulen 6, 7 und die Antennenanordnung 4 durch die Steuereinrichtung 3 gemäß der vorangehend ermittelten zu nutzenden Ansteuersequenz 25 anzusteuern. Hierbei betreffen die Ansteuerinformationen 27 beispielsweise die Gradientenspule 6, die Ansteuerinformationen 28 die Gradientenspule 7 und die Sendesignale, von denen beispielhaft nur die Sendesignale 29, 30, 31 dargestellt sind, jeweils einen der Hochfrequenzsendekanäle 5. Durch das Ausspielen dieser Ansteuersequenzen 25 werden die Messdaten 32 erfasst.

Fig. 4 stellt eine Möglichkeit, das in Schritt S2 durchgeführte Optimierungsverfahren 12 zu implementieren, detailliert dar. Hierbei werden die Referenzdatensätze 9 sowie eine Sollanregungsverteilung 33 als Eingangsdaten genutzt, um freie Parameter 35 einer zu optimierenden Ansteuersequenz 34 zu optimieren. Aus Übersichtlichkeitsgründen ist in Fig. 4 hierbei nur eine Optimierung für einen einzigen der Optimierungsparameter 47 vorgegeben. Für andere Werte des Optimierungsparameters kann das dargestellte Vorgehen anschließend mit geändertem Optimierungsparameter 13, 14, 15, 47 wiederholt bzw. parallel durchgeführt werden. Die Ansteuersequenz 34 kann beispielsweise zeitdiskret vorgegeben werden, wobei für jeden Zeitpunkt Amplituden und Phasen für die verschiedenen Hochfrequenzsendekanäle 5 sowie Gradientenstärken für die Gradientenspulen 6, 7 vorgegeben werden können. Selbstverständlich sind auch andere Parametrisierungen und Trajektorien möglich.

Durch einen Simulationsalgorithmus 36 wird für jeden der Referenzdatensätze 9 eine voraussichtlich erzielte Anregungsverteilung 37 ermittelt, die aus einem Ausspielen der Ansteuersequenz 34 für das durch den jeweiligen Referenzdatensatz 9 beschriebene Referenzuntersuchungsobjekt 8 voraussichtlich resultieren würden. Zudem bestimmt der Simulationsalgorithmus 36 für mehrere Bereiche des durch den jeweiligen Referenzdatensatz 9 beschriebenen Referenzuntersuchungsobjekts 8 einen jeweiligen erwarteten Energieeintrag 38, 39, 40. Die Energieeinträge können, wie prinzipiell aus dem Stand der Technik bekannt ist, anhand einer elektrodynamischen Simulation oder auch anhand von Feldverteilungskarten bestimmt werden.

Aus den erwarteten Energieeinträgen in die verschiedenen Bereiche wird für jedes der Referenzuntersuchungsobjekte der Bereich, in dem der höchste Energieeintrag 38, 39, 40 erwartet wird, als Referenzbereich gewählt, und der entsprechende Energieeintrag als Einzelenergieeintrag 41 für das entsprechende Referenzuntersuchungsobjekt und somit den entsprechenden Referenzdatensatz 9 und die entsprechend parametrisierte Ansteuersequenz 34 gewählt. Anschließend wird ein Mittelwert 42 der Einzelenergieeinträge 41 gebildet.

Die jeweils voraussichtlich erzielten Anregungsverteilungen 37 werden durch eine Vergleichsfunktion 43 mit der Sollanregungsverteilung 33 verglichen, um für jeden der Referenzdatensätze 9 ein Abweichungsmaß 44 zu bestimmen. Beispielsweise können die Sollanregungsverteilung 33 und die voraussichtlich erzielte Anregungsverteilung 37 voneinander subtrahiert werden und es kann beispielsweise die Standardabweichung für dieses Differenzbild als Abweichungsmaß 44 berechnet werden. Für die Abweichungsmaße 44 kann anschließend ein mittleres Abweichungsmaß 45 berechnet werden.

Das Abweichungsmaß 45 und ein Energieeintragsmaß 48, also beispielsweise der Mittelwert 42, sollen durch einen Optimierungsprozess gemeinsam minimiert werden. Hierzu wird eine Kostenfunktion 46 genutzt, die eine gewichtete Summe des Abweichungsmaßes 45 und des Energieeintragsmaßes 48 ist, wobei die Gewichtungsfaktoren durch den Optimierungsparameter 47 vorgegeben werden. Durch Wahl des Optimierungsparameters 47 kann somit eine Abwägung zwischen einer Optimierung bezüglich des Energieeintragsmaßes 48 und des Abweichungsmaßes 45 erfolgen.

In Abhängigkeit des Wertes der Kostenfunktion 46 werden durch einen Modifikationsalgorithmus 49 die Parameter 35 der Ansteuersequenz 34 modifiziert und das Verfahren wird wiederholt, um iterativ eine Optimierung der Parameter 35 durchzuführen. Hierzu können bekannte Optimierungsverfahren, beispielsweise ein Gradientenabstiegsverfahren, genutzt werden. Die Optimierung kann für eine bestimmte Anzahl von Durchgängen wiederholt werden oder bis ein Konvergenzkriterium erfüllt ist, beispielsweise bis sich ein Wert der Kostenfunktion 46 bei aufeinanderfolgenden Durchgängen nicht mehr wesentlich ändert.

Das Problem der Optimierung der Parameter 35 der Ansteuersequenz ist in der Regel ein nicht-konvexes Optimierungsproblem. Um zu vermeiden, dass ausschließlich ein lokales Optimum aufgefunden wird, kann das beschriebene Vorgehen für jeden Wert des Optimierungsparameters 47 mehrfach durchgeführt werden, wobei verschiedene Startpunkte, also Startwerte der Parameter 35, verwendet werden. Anschließend kann jenes Ergebnis genutzt werden, das zum kleinsten Wert der Kostenfunktion 46 führt.

Nach Abschluss der Optimierung für mehrere Optimierungsparameter 13, 14, 15, 47 kann, beispielsweise durch einen Regressionsalgorithmus 50, ein funktionaler Zusammenhang 51 zwischen einem jeweiligen ermittelten Mittelwert 42 der Einzelenergieeinträge 41 und dem jeweils genutzten Optimierungsparameter 13, 14, 47 bereitgestellt werden. Dies kann dazu dienen, im Rahmen der Auswahl der zu nutzenden Ansteuersequenz diese bzw. die im Rahmen der Ermittlung genutzte vorläufige bzw. neue vorläufige Ansteuersequenzen auszuwählen, wie später noch genauer erläutert werden wird.

Fig. 5 zeigt eine mögliche Implementierung des Schritts S4 in Fig. 2 bzw. des computerimplementierten Verfahrens 24 zur Bereitstellung einer zu nutzenden Ansteuersequenz.

In Schritt S6 wird zunächst ein Maximalwert für einen zulässigen Energieeintrag in das Untersuchungsobjekt 2 vorgegeben. Beispielsweise kann eine obere Grenze für den SED-Wert vorgegeben werden. Insbesondere kann der Grenzwert aus den SAR-Grenzwerten der International Electronical Commission (IEC) und den Sequenz- bzw. Protokollparametern ermittelt werden. Die SAR-Grenzwerte sind als Grenzen für die eingestrahlte Leistung angegeben. Hierbei erfolgt eine Mittelung über zehn Sekunden bzw. sechs Minuten. Anhand dieser Leistungsgrenzen können somit auch Grenzen für die während der gesamten Ansteuersequenz bzw. während eines Abschnitts der Ansteuersequenz eingestrahlte Energie angegeben werden.

In Schritt S7 wird in Abhängigkeit des vorgegebenen Grenzwertes bzw. Intervalls eine der Ansteuersequenzen ausgewählt. Ist der funktionale Zusammenhang 51 zwischen dem Mittelwert 42 und dem Optimierungsparameter 13, 14, 15, 47 bekannt, kann unmittelbar ein Optimierungsparameter und somit auch eine zugeordnete Ansteuersequenz gewählt werden, deren durchschnittlicher Energieeintrag für die Referenzuntersuchungsobjekte unterhalb des Grenzwertes bzw. in dem vorgegebenen Intervall liegt. Sind die Ansteuersequenzen hingegen unmittelbar Mittelwerte der Einzelenergieeinträge zugeordnet, kann auch in diesem Fall unmittelbar eine Ansteuersequenz gewählt werden, für die der Mittelwert der Einzelenergieeinträge kleiner als der Grenzwert ist bzw. im Intervall liegt. Prinzipiell wäre es auch möglich, die vorläufige Ansteuersequenz auf andere Weise auszuwählen, beispielsweise zufällig.

In Schritt S8 werden die Feldverteilungskarten, insbesondere $B_0$- und $B_1$-Karten, für das Untersuchungsobjekt 2 bereitgestellt. Die Feldverteilungskarten können über eine Schnittstelle einer das Verfahren implementierenden Einrichtung aus beliebiger Quelle empfangen werden, also beispielsweise aus einer Datenbank ausgelesen werden. Es ist jedoch auch möglich, die Feldverteilungskarten innerhalb des Verfahrens selbst zu erfassen.

In Schritt S9 wird ein Energieeintrag in einen ausgewählten Bereich des Untersuchungsobjekts bei einer Nutzung der in Schritt S7 vorgegebenen vorläufigen Ansteuerungssequenz prognostiziert. Hierbei kann, wie bereits mit Bezug auf Fig. 4 für die Ermittlung von Energieeinträgen in Referenzuntersuchungsobjekte erläutert wurde, zunächst ein Energieeintrag in mehrere verschiedene Bereiche des Untersuchungsobjekts prognostiziert werden. Vorzugsweise werden hierbei die bereits vorangehend erläuterten Virtual Observation Points genutzt, also ein Energieeintrag in Bereiche berechnet, die nicht notwendig zusammenhängen, für die jedoch ein ähnliches Verhalten erwartet wird. Anschließend kann jener Bereich ausgewählt werden, in den der größte Energieeintrag erfolgt und dieser Energieeintrag kann in Schritt S10 verwendet werden, um zu entscheiden, ob eine Nutzungsbedingung erfüllt ist.

Ist die Nutzungsbedingung in Schritt S10 erfüllt, was insbesondere der Fall ist, wenn der Energieeintrag kleiner als ein Grenzwert ist bzw. innerhalb eines vorgegebenen Intervalls liegt, so wird das Verfahren in Schritt S11 fortgesetzt, in dem die in Schritt S7 vorgegebene vorläufige Ansteuersequenz als zu nutzende Ansteuersequenz ausgewählt und bereitgestellt wird.

Anderenfalls wird das Verfahren ab Schritt S7 wiederholt. In Schritt S7 wird eine neue vorläufige Ansteuersequenz ausgewählt. Prinzipiell ist es möglich, die neue, vorläufige Ansteuersequenz zufällig auszuwählen. Bevorzugt wird jedoch berücksichtigt, in welche Richtung und wie weit der in Schritt S9 ermittelte Energieeintrag von dem Grenzwert bzw. von dem Intervall abweicht. Dies kann zu einer erheblich schnelleren Ermittlung einer Ansteuersequenz im gewünschten Energieeintragsintervall bzw. unterhalb des Grenzwertes führen.

Hierbei kann insbesondere der funktionale Zusammenhang 51 zwischen den Optimierungsparametern und den zugeordneten Mittelwerten 42 der einzelnen Energieeinträgen 41 genutzt werden, dessen Bereitstellung mit Bezug auf Figur 4 erläutert wurde. Wurde beispielsweise ermittelt, dass der prognostizierte Energieeintrag für die vorläufige Ansteuersequenz um einen bestimmten Offset oder Faktor größer oder kleiner als der Mittelwert der einzelnen Energieeinträge für diese Ansteuersequenz ist, können der Grenzwert bzw. die Intervallgrenze mit diesem Faktor bzw. Offset korrigiert werden, um modifizierte Sollwerte für den Energieeintrag zu bestimmen. Anhand des funktionalen Zusammenhanges 51 kann aus diesem modifizierten Sollwert für den Energieeintrag ein Sollwert für den Optimierungsparameter bestimmt werden. Es kann somit eine Ansteuersequenz gewählt werden, deren Optimierungsparameter diesem Solloptimierungsparameter möglichst nahe kommt. Durch das beschriebene Vorgehen kann auch bei einer Nutzung einer großen Anzahl von verschiedenen Ansteuersequenzen, beispielsweise bei einigen 10 oder 100 Ansteuersequenzen, die zu nutzende Ansteuersequenz innerhalb weniger Iterationen ermittelt werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, sofern diese den Schutzumfang der Erfindung nicht verlassen, der durch die beigefügten Ansprüche definiert ist.

**Patentansprüche**

1. Computerimplementiertes Verfahren zur Bereitstellung einer zu nutzenden Ansteuersequenz (25), die für eine Erfassung von Messdaten (32) eines Untersuchungsobjekts (2) durch eine Magnetresonanzeinrichtung (1) für mindestens einen Hochfrequenzsendekanal (5) einer Antennenanordnung (4) der Magnetresonanzeinrichtung (1) jeweilige abzustrahlende Sendesignale (29 - 31) vorgibt, umfassend die Schritte:

    - Bereitstellen von verschiedenen Ansteuersequenzen (16 - 18, 34), die jeweils das Ergebnis eines Optimierungsverfahrens (12) sind und sich bezüglich des Wertes eines im Rahmen des Optimierungsverfahrens berücksichtigten Optimierungsparameters (13 - 15, 47) unterscheiden (S2),
    - Bereitstellen von mehreren durch die oder eine weitere Magnetresonanzeinrichtung (1) an dem Untersuchungsobjekt (2) erfassten Feldverteilungskarten (21) (S3),
    - Auswahl der zu nutzenden Ansteuersequenz (25) aus den verschiedenen Ansteuersequenzen (16 - 18, 34) in Abhängigkeit der Feldverteilungskarten (21) und Bereitstellung der zu nutzenden Ansteuersequenz (25) (S4), **dadurch gekennzeichnet, dass** die verschiedenen Ansteuersequenzen (16 - 18, 34) Ergebnisse eines Optimierungsverfahrens (12) sind, in dessen Rahmen eine Kostenfunktion (46) minimiert wird, die eine gewichtete Summe ist aus

        - einem Energieeintragsmaß (48), das einen erwarteten Energieeintrag in einen Referenzbereich wenigstens eines durch einen jeweiligen Referenzdatensatz (9) beschriebenen Referenzuntersuchungsobjekts (8) bei Nutzung einer zu optimierenden Ansteuersequenz (16 - 18, 34) betrifft, und
        - einem Abweichungsmaß (45), das eine Abweichung einer im Rahmen der Ansteuersequenz (34) in dem Referenzuntersuchungsobjekt (8) voraussichtlich erzielten Anregungsverteilung (37) von einer Sollanregungsverteilung (33) betrifft,

    wobei die relative Gewichtung des Energieeintragsmaßes (48) und des Abweichungsmaßes (45) durch den Optimierungsparameter (47) vorgegeben wird,
    dass aus den verschiedenen Ansteuersequenzen (16 - 18, 34) eine vorläufige Ansteuersequenz (16 - 18, 34) ausgewählt wird und in Abhängigkeit der Feldverteilungskarten (21) und der vorläufigen Ansteuersequenz (16 - 18, 34) ein Energieeintrag in einen ausgewählten Bereich des Untersuchungsobjekts (2) bei einer Nutzung der vorläufigen Ansteuersequenz (16 - 18) zur Erfassung der Messdaten (32) prognostiziert wird,

    i) wobei die vorläufige Ansteuersequenz als die zu nutzende Ansteuersequenz (25) ausgewählt wird, wenn der prognostizierte Energieeintrag innerhalb eines vorgegebenen Intervalls liegt oder, wenn der prognostizierte Energieeintrag außerhalb des vorgegebenen Intervalls liegt, eine neue vorläufige Ansteuersequenz (16 - 18, 34) aus den verschiedenen Ansteuersequenzen (16 - 18, 34) ausgewählt wird und Schritt i) so oft wiederholt wird, bis der prognostizierte Energieeintrag innerhalb des vorgegebenen Intervalls liegt.

2. Computerimplementiertes Verfahren nach Anspruch 1, **dadurch gekennzeichnet, dass** das Bereitstellen von mehreren durch die oder eine weitere Magnetresonanzeinrichtung (1) an dem Untersuchungsobjekt (2) erfassten Feldverteilungskarten (21) ein Bereitstellen wenigstens einer $B_0$-Karte und/oder wenigstens einer $B_1$-Karte umfasst.

3. Computerimplementiertes Verfahren nach einem der vorangehenden Ansprüche, **dadurch gekennzeichnet, dass** für mehrere Bereiche des Untersuchungsobjekts ein jeweiliger prognostizierter Energieeintrag ermittelt wird, wobei jener der Bereiche, für den der prognostizierte Energieeintrag am größten ist, ausgewählt wird, wobei die zu nutzende Ansteuersequenz oder die neue vorläufige Ansteuersequenz in Abhängigkeit des prognostizierten Energieeintrags in diesem ausgewählten Bereich gewählt wird.

4. Computerimplementiertes Verfahren nach einem der vorangehenden Ansprüche, **dadurch gekennzeichnet, dass** in dem Optimierungsverfahren (12) mehrere Referenzuntersuchungsobjekte (8) berücksichtigt werden,

   wobei für jedes der Referenzuntersuchungsobjekte (8) und jede der verschiedenen Ansteuersequenzen (16 - 18, 34), ein Einzelenergieeintrag (41) ermittelt wird, der einen erwarteten Energieeintrag in den Referenzbereich dieses Referenzuntersuchungsobjekts (8) bei Nutzung dieser Ansteuersequenz (16 - 18, 34) betrifft, wobei für jede der verschiedenen Ansteuersequenzen (16 - 18, 34) ein Mittelwert (42) der Einzelenergieeinträge (41) bestimmt und dem zur Ermittlung der jeweiligen Ansteuersequenz (16 - 18, 34) genutzten Optimierungsparameter (47) oder der Ansteuersequenz (16 - 18, 34) selbst zugeordnet wird.

5. Computerimplementiertes Verfahren nach Anspruch 4,
   **dadurch gekennzeichnet, dass** für die jeweilige Ansteuersequenz (16 - 18, 34) für mehrere Bereiche des jeweiligen Referenzuntersuchungsobjekts (8) ein jeweiliger erwarteter Energieeintrag (38 - 40) ermittelt wird, wobei als Einzelenergieeintrag (41) für diese Ansteuersequenz (16 - 18, 34) und dieses Referenzuntersuchungsobjekt (8) der größte dieser erwarteten Energieeinträge (38 - 40) gewählt wird.

6. Computerimplementiertes Verfahren nach Anspruch 4 oder 5, **dadurch gekennzeichnet, dass** in Abhängigkeit der den jeweiligen Optimierungsparametern (47) zugeordneten Mittelwerte (42) der Einzelenergieeinträge (41) ein funktionaler Zusammenhang (51) zwischen den Optimierungsparametern (47) und den zugeordneten Mittelwerten (42) ermittelt wird,
   wobei die zu nutzenden Ansteuersequenz (25) und/oder die vorläufige und/oder die neue vorläufige Ansteuersequenz (16 - 18, 34) in Abhängigkeit dieses funktionalen Zusammenhangs (51) gewählt werden.

7. Computerimplementiertes Verfahren nach einem der vorangehenden Ansprüche, **dadurch gekennzeichnet, dass** die verschiedenen Ansteuersequenzen (16 - 18, 34) zusätzlich jeweils Ansteuerinformationen (27, 28) zur Ansteuerung wenigstens einer Gradientenspule (6, 7) zur Bereitstellung eines Gradientenfeldes umfassen.

8. Verfahren zur Erfassung von Messdaten eines Untersuchungsobjekts (2), insbesondere zur medizinischen Bildgebung, durch eine Magnetresonanzeinrichtung (1), **dadurch gekennzeichnet, dass** durch eine Antennenanordnung (4) der Magnetresonanzeinrichtung (1) im Rahmen der Messdatenerfassung über mindestens einen Hochfrequenzsendekanal (5) Sendesignale (29 - 31) abgestrahlt werden, die durch eine Ansteuersequenz (25) vorgegeben werden, die durch ein Verfahren nach einem der vorangehenden Ansprüche ausgewählt wird.

9. Verfahren nach Anspruch 8, **dadurch gekennzeichnet, dass** durch die Magnetresonanzeinrichtung (1) die Feldverteilungskarten (21) erfasst werden.

10. Bereitstellungs- und/oder Magnetresonanzeinrichtung, **dadurch gekennzeichnet, dass** sie zur Durchführung des computerimplementierten Verfahrens nach einem der Ansprüche 1 bis 7 und/oder zur Durchführung des Verfahrens nach Anspruch 8 oder 9 eingerichtet ist.

11. Computerprogramm für eine Datenverarbeitungseinrichtung, mit Programmanweisungen, die bei einer Durchführung auf einer Datenverarbeitungseinrichtung (20) ein computerimplementiertes Verfahren nach einem der Ansprüche 1 bis 7 durchführt und/oder Computerprogramm für eine Magnetresonanzeinrichtung umfassend Befehle, die bewirken, dass die Magnetresonanzeinrichtung die Verfahrensschritte nach Anspruch 8 oder 9 durchführt.

12. Computerlesbarer Datenträger, umfassend ein Computerprogramm nach Anspruch 11.

**Claims**

1. Computer-implemented method for providing an actuation sequence (25) to be used which specifies transmit signals (29-31) to be emitted for at least one high-frequency transmit channel (5) of an antenna arrangement (4) of a magnetic resonance device (1) for acquiring measurement data (32) of an object (2) under investigation by the magnetic resonance device (1), comprising the steps of:

   - providing different actuation sequences (16-18, 34), each of which is the result of an optimisation method (12) and which differ with regard to the value of an optimisation parameter (13-15, 47) taken into account in the course of the optimisation method (S2),
   - providing a plurality of field distribution maps (21) acquired by the or a further magnetic resonance device (1) from the object under investigation (2) (S3),

- selecting the actuation sequence (25) to be used from the different actuation sequences (16-18, 34) depending on the field distribution maps (21) and providing the actuation sequence (25) to be used (S4),

**characterised in that** the different actuation sequences (16-18, 34) are results of an optimisation method (12), in the course of which a cost function (46) is minimised which is a weighted sum of

- an energy input measure (48) which relates to an anticipated energy input into a reference region of at least one reference object (8) under investigation which is described by a respective reference data set (9) in the event of an actuation sequence (16-18, 34) to be optimised being used, and

- a deviation measure (45) which relates to a deviation of an excitation distribution (37) which is expected to be achieved in the reference object (8) under investigation in the course of the actuation sequence (34) from a nominal excitation distribution (33),

wherein the relative weighting of the energy input measure (48) and the deviation measure (45) is specified by the optimisation parameter (47),

that a provisional actuation sequence (16-18, 34) is selected from the different actuation sequences (16-18, 34) and, depending on the field distribution maps (21) and the provisional actuation sequence (16-18, 34), an energy input into a selected region of the object under investigation (2) in the event of the provisional actuation sequence (16-18) being used for acquiring the measurement data (32) is forecast,

  i) wherein the provisional actuation sequence is selected as the actuation sequence (25) to be used if the forecast energy input is within a specified interval or, if the forecast energy input is outside the specified interval, a new provisional actuation sequence (16-18, 34) is selected from the different actuation sequences (16-18, 34) and step i) is repeated until the forecast energy input is within the specified interval.

2. Computer-implemented method according to claim 1, **characterised in that** the providing of a plurality of field distribution maps (21) acquired by the or a further magnetic resonance device (1) from the object under investigation (2) comprises providing at least one $B_0$ map and/or at least one $B_1$ map.

3. Computer-implemented method according to one of the preceding claims, **characterised in that** a respective forecast energy input is ascertained for a plurality of regions of the object under investigation,

wherein that one of the regions for which the forecast energy input is highest is selected, wherein the actuation sequence to be used or the new provisional actuation sequence is selected depending on the forecast energy input in this selected region.

4. Computer-implemented method according to one of the preceding claims, **characterised in that** the optimisation method (12) takes account of a plurality of reference objects (8) under investigation,

wherein, for each of the reference objects (8) under investigation and each of the different actuation sequences (16-18, 34), an individual energy input (41) is ascertained which relates to an anticipated energy input into the reference region of this reference object (8) under investigation in the event of this actuation sequence (16-18, 34) being used, wherein, for each of the different actuation sequences (16-18, 34), a mean (42) of the individual energy inputs (41) is determined and assigned to the optimisation parameter (47) used for ascertaining the respective actuation sequence (16-18, 34) or to the actuation sequence (16-18, 34) itself.

5. Computer-implemented method according to claim 4, **characterised in that** a respective anticipated energy input (38-40) is ascertained for the respective actuation sequence (16-18, 34) for a plurality of regions of the respective reference object (8) under investigation, wherein the largest of these anticipated energy inputs (38-40) is selected as the individual energy input (41) for this actuation sequence (16-18, 34) and this reference object (8) under investigation.

6. Computer-implemented method according to claim 4 or 5, **characterised in that**, depending on the means (42) of the individual energy inputs (41) assigned to the respective optimisation parameters (47), a functional relationship (51) is ascertained between the optimisation parameters (47) and the assigned means (42),

wherein the actuation sequence (25) to be used and/or the provisional and/or the new provisional actuation sequence (16-18, 34) are selected depending on this functional relationship (51).

7. Computer-implemented method according to one of the preceding claims, **characterised in that** the different actuation sequences (16-18, 34) in each case additionally comprise actuation information (27, 28) for actuating at least one gradient coil (6, 7) for providing a gradient field.

8. Method for acquiring measurement data of an object under investigation (2), in particular for medical imaging, by a magnetic resonance device (1), **characterised in that** transmit signals (29-31) are emitted by an antenna arrangement (4) of the magnetic resonance device (1) in the course of measurement data acquisition via at least one high-frequency transmit channel (5), which signals are specified by an actuation sequence (25) which is selected by a method according to one of the preceding claims.

9. Method according to claim 8, **characterised in that** the field distribution maps (21) are acquired by the magnetic resonance device (1).

10. Provision and/or magnetic resonance device, **characterised in that** it is designed to carry out the computer-implemented method according to one of claims 1 to 7 and/or to carry out the method according to claim 8 or 9.

11. Computer program for a data processing device having program statements which a computer-implemented method according to one of claims 1 to 7 carries out when carried out on a data processing device (20), and/or computer program for a magnetic resonance device comprising commands that cause the magnetic resonance device to carry out the method steps according to claim 8 or 9.

12. Computer-readable data storage medium comprising a computer program according to claim 11.

**Revendications**

1. Procédé mis en oeuvre par ordinateur pour disposer d'une séquence (25) de commande à utiliser, qui, pour une saisie de données (32) de mesure d'un objet (2) en examen par un dispositif (1) de résonnance magnétique, prescrit, pour au moins un canal (5) d'émission en haute fréquence d'un agencement (4) d'antennes du dispositif (1) de résonnance magnétique, des signaux (29 - 31) d'émission respectifs à envoyer, comprenant les stades :

     - on se procure diverses séquences (16 - 18, 34) de commande, qui sont respectivement le résultat d'un procédé (12) d'optimisation et qui se distinguent en ce qui concerne la valeur d'un paramètre (13 - 15, 47) d'optimisation pris en compte dans le cadre du procédé d'optimisation (S2),
     - on se procure plusieurs cartes (21) de répartition du champ détectées sur l'objet (2) en examen par le ou par un autre dispositif (1) de résonnance magnétique (S3),
     - on choisit la séquence (25) de commande à utiliser parmi les diverses séquences (16 - 18, 34) de commande en fonction des cartes (21) de répartition du champ et on met à disposition la séquence (25) de commande à utiliser (S4), **caractérisé en ce que** les diverses séquences (16 - 18, 34) de commande sont des résultats d'un procédé (12) d'optimisation, dans le cadre duquel on minimise une fonction (46) de coût, qui est une somme pondérée de

     - une mesure (48) d'apport d'énergie, qui concerne un apport d'énergie escompté dans une partie de référence d'au moins un objet (8) de référence en examen décrit par un ensemble (9) respectif de données de référence, lors de l'utilisation d'une séquence (16 - 18, 34) de commande à optimiser, et
     - une mesure (45) d'écart, qui concerne un écart d'une répartition (37) d'excitation, obtenue probablement dans l'objet (8) de référence en examen dans le cadre de la séquence (34) de commande, à une répartition (33) d'excitation de consigne,

dans lequel on prescrit la pondération relative de la mesure (48) d'apport d'énergie et de la mesure (45) d'écart par le paramètre (47) d'optimisation,

**en ce que** l'on choisit, à partir des diverses séquences (16 - 18, 34) de commande, une séquence (16 - 18, 34) de commande provisoire et on prévoit, en fonction des cartes (21) de répartition du champ et de la séquence (16 - 18, 34) de commande provisoire, un apport d'énergie dans une partie sélectionnée de l'objet (2) en examen lors d'une utilisation de la séquence (16 - 18) de commande provisoire pour la saisie des données (32) de mesure,

     i) dans lequel on choisit la séquence de commande provisoire comme la séquence (25) de commande à utiliser, si l'apport d'énergie prévu est dans un intervalle donné à l'avance ou, si l'apport d'énergie prévu est en dehors d'un intervalle donné à l'avance, on choisit une nouvelle séquence (16 - 18, 34) de commande provisoire à partir des diverses séquences (16 - 18, 34) de commande et on répète le stade i) jusqu'à ce que l'apport d'énergie prévu soit dans l'intervalle donné à l'avance.

2. Procédé mis en oeuvre par ordinateur suivant la revendication 1, **caractérisé en ce que** la mise à disposition de plusieurs cartes (21) de répartition du champ détectées par le un autre dispositif (1) de résonnance magnétique sur l'objet (2) en examen comprend une mise à disposition d'au moins d'une carte $B_0$ et/ou d'au moins une carte $B_i$.

**3.** Procédé mis en oeuvre par ordinateur suivant l'une des revendications précédentes, **caractérisé en ce que** l'on détermine, pour plusieurs parties de l'objet en examen, un apport d'énergie prévu respectif, dans lequel on choisit chacune des parties pour laquelle l'apport d'énergie prévu est le plus grand, dans lequel on choisit la séquence de commande à utiliser ou la nouvelle séquence de commande provisoire en fonction de l'apport d'énergie prévu dans cette partie choisie.

**4.** Procédé mis en oeuvre par ordinateur suivant l'une des revendications précédentes, **caractérisé en ce que**, dans le procédé (12) d'optimisation, on prend en compte plusieurs objets (8) de référence en examen,
dans lequel, pour chacun des objets (8) de référence en examen et chacune des diverses séquences (16 - 18, 34) de commande, on détermine un apport (41) d'énergie propre, qui concerne un apport d'énergie escompté dans la partie de référence de cet objet (8) de référence en examen, lors de l'utilisation de cette séquence (16 - 18, 34) de commande, dans lequel, pour chacune des séquences (16 - 18, 34) de commande différentes, on détermine une valeur (42) moyenne des apports (41) d'énergie propre et on l'affecte soi-même à la séquence (16 - 18, 34) de commande ou au paramètre (47) d'optimisation utilisé pour la détermination de la séquence (16- 18, 34) de commande respective.

**5.** Procédé mis en oeuvre par ordinateur suivant la revendication 4, **caractérisé en ce que**, pour la séquence (16 - 18, 34) de commande respective, on détermine, pour plusieurs parties de l'objet (8) de référence en examen respectif, un apport (38 - 40) d'énergie escompté respectif,
dans lequel on choisit, comme apport (41) d'énergie propre, pour cette séquence (16 - 18, 34) de commande et cet objet (8) de référence en examen, le plus grand de ces apports (38 - 40) d'énergie escomptés.

**6.** Procédé mis en oeuvre par ordinateur suivant la revendication 4 ou 5, **caractérisé en ce que**, en fonction des valeurs (42) moyennes, affectées aux paramètres (47) d'optimisation respectifs, des apports (41) d'énergie propres, on détermine une relation (51) fonctionnelle entre les paramètres (47) d'optimisation et les valeurs (42) moyennes à affecter, dans lequel on choisit la séquence (25) de commande à utiliser et/ou la séquence (16 - 18, 34) provisoire de commande et/ou la nouvelle séquence provisoire de commande, en fonction de cette relation (51) fonctionnelle.

**7.** Procédé mis en oeuvre par ordinateur suivant l'une des revendications précédentes, **caractérisé en ce que** les diverses séquences (16 - 18, 34) de commande comprennent en outre respectivement des informations (27, 28) de commande pour la commande d'au moins une bobine (6, 7) de gradient pour disposer d'un champ de gradient.

**8.** Procédé de saisie de données de mesure d'un objet (2) en examen, en particulier pour l'imagerie médicale, par un dispositif (1) de résonnance magnétique,
**caractérisé en ce que**, par un agencement (4) d'antennes du dispositif (1) de résonnance magnétique, on envoie, dans le cadre de la saisie de données de mesure, par au moins un canal (5) d'émission en haute fréquence des signaux (29 - 31) d'émission, qui sont prescrits par une séquence (25) de commande, que l'on choisit par un procédé suivant l'une des revendications précédentes.

**9.** Procédé suivant la revendication 8, **caractérisé en ce que** l'on détecte des cartes (21) de répartition du champ par le dispositif (1) de résonnance magnétique.

**10.** Dispositif de mise à disposition et/ou de résonnance magnétique, **caractérisé en ce qu'**il est agencé pour effectuer le procédé mis en oeuvre par ordinateur suivant l'une des revendications 1 à 7 et/ou pour effectuer le procédé suivant la revendication 8 ou 9.

**11.** Programme d'ordinateur pour un dispositif de traitement de données ayant des instructions de programme qui, lorsqu'elles sont effectuées sur un dispositif (20) de traitement de données, exécutent un procédé mis en oeuvre par ordinateur suivant l'une des revendications 1 à 7 et/ou des instructions comprenant un programme d'ordinateur pour un dispositif de résonnance magnétique, qui font que le dispositif de résonnance magnétique exécute les stades du procédé suivant la revendication 8 ou 9.

**12.** Support de données, déchiffrable par ordinateur, comprenant un programme d'ordinateur suivant la revendication 11.

FIG 1

FIG 2

FIG 3

# FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2017060142 A1
- DE 102007013422 B4
- US 2018011155 A1

**In der Beschreibung aufgeführte Nicht-Patentliteratur**

- **GRASS, V.** Universal Pulses: A new concept for calibration-free parallel transmission. *Magnetic Resonance in Medicine,* 2017, vol. 77, 635-643
- **CLOOS, M. A. et al.** kT-Points: Short three-dimensional tailored RF-Pulses for flip-angle homogenization over an extended volume. *Magnetic Resonance in Medicine,* 2012, vol. 67, 72-80
- **GRAESSLIN, I. et al.** A specific absorption rate prediction concept for parallel transmission MR. *Magnetic Resonance in Medicine,* 2012, vol. 68, 1664-1674
- **EICHFELDER, G. et al.** Local Specific Absorption Rate Control for Parallel Transmission by Virtual Observation Points. *Magnetic Resonance in Medicine,* 2011, vol. 66, 1468-1476
- **ZHANG, X. et al.** Complex B1 mapping and electrical properties imaging of the human brain using a 16-channel transceiver coil at 7T. *Magnetic Resonance in Medicine,* 2013, vol. 69, 1285-1296
- **VAN DEN BERGEN et al.** 7 T body MRI: B1 shimming with simultaneous SAR reduction. *Phys Med Biol,* 2007, vol. 52 (17), 5429-5441